(19) Europäisches Patentamt
European Patent Office
Office européen des brevets

(11) EP 2 685 267 B1

(12) FASCICULE DE BREVET EUROPEEN

(45) Date de publication et mention de la délivrance du brevet:
**14.11.2018 Bulletin 2018/46**

(51) Int Cl.:
***G01R 29/18*** *(2006.01)*

(21) Numéro de dépôt: **13175647.0**

(22) Date de dépôt: **09.07.2013**

# (54) Procéde et système de mesure à l'identification des phases

Verfahren und System zum Messen mit Identifizierung der Phasen

Method and system for measuring involving phase identification

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.07.2012 FR 1256637**

(43) Date de publication de la demande:
**15.01.2014 Bulletin 2014/03**

(73) Titulaire: **Schneider Electric Industries SAS**
**92500 Rueil-Malmaison (FR)**

(72) Inventeurs:
- **Deschamps, Philippe**
  **38800 LE PONT DE CLAIX (FR)**
- **Coutelou, Olivier**
  **38000 GRENOBLE (FR)**

(74) Mandataire: **Lavoix**
**62, rue de Bonnel**
**69448 Lyon Cedex 03 (FR)**

(56) Documents cités:
**WO-A1-2009/057164**
**WO-A1-2010/065591**
**JP-A- 2003 057 286**
**US-A- 5 055 769**
**US-A1- 2007 279 039**
**US-A1- 2010 109 650**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 685 267 B1

## Description

La présente invention concerne un système de mesure d'au moins une grandeur électrique relative à une installation électrique, l'installation électrique comportant des conducteurs électriques propres à permettre la circulation d'un courant alternatif triphasé.

Ce système de mesure comprend un organe de mesure de la tension de chacun des conducteurs électriques, chaque conducteur électrique étant associé à une phase respective du réseau alternatif, une unité de traitement d'informations propre à recevoir les valeurs des tensions mesurées, et trois capteurs de courant, chaque capteur de courant étant propre à mesurer l'intensité du courant circulant dans le conducteur électrique correspondant.

La présente invention concerne également un poste de transformation d'un courant électrique présentant une première tension alternative en un courant électrique présentant une deuxième tension alternative, ce poste de transformation comprenant un tel système de mesure.

La présente invention concerne également un procédé de mesure d'au moins une grandeur électrique à l'aide d'un tel système de mesure.

On connaît du document US 7,425,778 B2 un système de mesure du type précité. Le système de mesure appartient à un relais de protection différentielle connecté au primaire et au secondaire d'un transformateur. Ce système de mesure permet notamment de détecter un éventuel croisement de connexions entre phases au niveau des entrées du relais de protection différentielle. A cet effet, l'unité de traitement d'informations du système de mesure calcule le courant au cours d'une séquence négative en tant que pourcentage du courant au cours d'une séquence positive, et déclare une erreur de connexion lorsque la quantité de courant au cours d'une séquence négative est supérieure à un taux prédéfini, tel qu'un taux de 10%. Voir aussi WO2010/065591 et US2007/0279039.

Toutefois, un tel système de mesure indique, le cas échéant, seulement une erreur de connexion, sans fournir davantage de précisions.

Le but de l'invention est donc de proposer un système de mesure d'au moins une grandeur électrique relative à une installation électrique polyphasée permettant d'identifier la phase correspondant à chacune des tensions mesurées.

A cet effet, l'invention a pour objet un système de mesure du type précité, caractérisé en ce que l'unité de traitement comprend des moyens d'association de manière prédéterminée de la première tension mesurée avec une première phase parmi les trois phases, un premier dispositif d'identification de la phase correspondant à chacune des deux autres tensions mesurées et un deuxième dispositif d'identification de la phase correspondant à chacune des trois intensités mesurées.

Suivant d'autres aspects avantageux de l'invention, le système de mesure comprend une ou plusieurs des caractéristiques suivantes, prises isolément ou suivant toutes les combinaisons techniquement possibles :

- le premier dispositif d'identification comporte des premiers moyens de détermination du vecteur de Fresnel de chacune des trois tensions mesurées, des premiers moyens de calcul d'un vecteur image via une première rotation du vecteur de Fresnel d'une parmi les deux autres tensions mesurées et des premiers moyens de comparaison du vecteur image avec le vecteur de Fresnel de la première tension mesurée ;
- un indice $k_p$ est associé à chaque phase à identifier, l'indice $k_p$ étant un nombre entier égal à 1 pour la première phase et prenant successivement les valeurs entières égales à 2 et 3 pour les autres phases, et la valeur de l'angle de la première rotation dépend de l'indice $k_p$ de la phase à identifier, la valeur de l'angle de la première rotation étant de préférence égale à $(k_p-1) \times 120$ ;
- le deuxième dispositif d'identification comporte des deuxièmes moyens de détermination du vecteur de Fresnel de chacune des trois intensités mesurées, des deuxièmes moyens de calcul de trois vecteurs image via une deuxième rotation des vecteurs de Fresnel des trois intensités mesurées et des deuxièmes moyens de comparaison, avec un intervalle prédéterminé de valeurs angulaires, de la valeur de l'angle entre chaque vecteur image et un axe de référence ;
- un indice $k_p$ est associé à chaque phase à identifier, l'indice $k_p$ étant un nombre entier égal à 1 pour la première phase et prenant successivement les valeurs entières égales à 2 et 3 pour les autres phases, et dans lequel la valeur de l'angle de la deuxième rotation dépend de l'indice $k_p$ de l'intensité mesurée ;
- la valeur de l'angle de la deuxième rotation est égale à $((k_p-1) \times 120°) - R$, où R représente la valeur de l'angle entre le vecteur de Fresnel de la première tension mesurée et l'axe de référence ;
- le deuxième dispositif d'identification comporte des deuxièmes moyens de détermination du vecteur de Fresnel de chacune des trois intensités mesurées, et des troisièmes moyens de comparaison, pour chaque intensité mesurée, des coordonnées du vecteur de Fresnel de ladite intensité mesurée avec les coordonnées du vecteur de Fresnel d'une tension mesurée respective ;
- le système de mesure comprend en outre un dispositif d'indication de fin d'identification propre à émettre un premier signal, tel qu'un premier signal lumineux, lorsque le premier dispositif a identifié la phase correspondant à chacune des tensions mesurées ; et

- le système de mesure est prévu pour une installation électrique comportant des conducteurs électriques primaires et des conducteurs électriques secondaires propres à permettre la circulation du courant alternatif, chaque conducteur électrique secondaire étant relié électriquement à un conducteur électrique primaire correspondant, le conducteur primaire et le conducteur secondaire correspondant présentant sensiblement la même tension alternative,

dans lequel le système de mesure comprend :

+ un module primaire comportant l'organe de mesure de la tension, l'organe de mesure de la tension étant propre à mesurer la tension de chaque conducteur primaire,
+ au moins un module secondaire comportant les trois capteurs de courant, chaque capteur de courant étant propre à mesurer l'intensité du courant circulant dans le conducteur secondaire correspondant, le ou chaque module secondaire étant relié au module primaire par une liaison de données correspondante,

le module primaire comportant en outre des moyens d'émission, à destination du récepteur radioélectrique du ou de chaque module secondaire, d'un premier message contenant les valeurs de tensions mesurées,
le ou chaque module secondaire comportant des moyens de réception du premier message, et
le système de mesure comprenant des moyens de synchronisation temporelle des intensités mesurées par rapport aux tensions mesurées.

L'invention a également pour objet un poste de transformation d'un courant électrique présentant une première tension alternative triphasée en un courant électrique présentant une deuxième tension alternative triphasée, le poste de transformation comprenant :

- un premier tableau comportant des conducteurs électriques d'arrivée propres à être relié à un réseau électrique, chaque conducteur d'arrivée étant associé à une phase respective de la première tension alternative,
- un deuxième tableau comportant des conducteurs électriques primaires de départ et des conducteurs électriques secondaires de départ, chaque conducteur secondaire de départ étant connecté électriquement à un conducteur primaire de départ correspondant, chaque conducteur de départ étant associé à une phase respective de la deuxième tension alternative,
- un transformateur électrique connecté entre le premier tableau et le deuxième tableau et propre à transformer la première tension alternative en la deuxième tension alternative, et
- un système de mesure d'au moins une grandeur électrique relative au deuxième tableau,

caractérisé en ce que le système de mesure est tel que défini ci-dessus.

L'invention a également pour objet un procédé de mesure d'au moins une grandeur électrique relative à une installation électrique, l'installation comportant des conducteurs électriques propres à permettre la circulation d'un courant alternatif triphasé, le procédé comprenant les étapes suivantes :

- la mesure, par un organe de mesure, de la tension de chacun des conducteurs électriques, chaque conducteur électrique étant associé à une phase respective du réseau alternatif,
- la réception, par une unité de traitement d'informations, des valeurs des tensions mesurées,

le procédé étant caractérisé en ce qu'il comprend en outre les étapes suivantes :

- l'association, par l'unité de traitement d'informations, de manière prédéterminée de la première tension mesurée avec une première phase parmi les trois phases,
- l'identification, par un premier dispositif d'identification, de la phase correspondant à chacune des deux autres tensions mesurées,
- la mesure, par trois capteurs de courant, de l'intensité du courant circulant dans chacun des conducteurs électriques, et
- l'identification, par un deuxième dispositif d'identification, de la phase correspondant à chacune des trois intensités mesurées.

Suivant d'autres aspects avantageux de l'invention, le procédé de mesure comprend une ou plusieurs des caractéristiques suivantes, prises isolément ou suivant toutes les combinaisons techniquement possibles :

- l'étape d'identification de la phase correspondant à chacune des trois intensités mesurées comporte la détermination du vecteur de Fresnel de chacune des trois intensités mesurées, le calcul de trois vecteurs image via une deuxième rotation des vecteurs de Fresnel des trois intensités mesurées et la comparaison, avec un intervalle prédéterminé de valeurs angulaires de la valeur de l'angle entre chaque vecteur image et un axe de référence ; et

- un indice $k_p$ est associé à chaque phase à identifier, l'indice $k_p$ étant un nombre entier égal à 1 pour la première phase et prenant successivement les valeurs entières égales à 2 et 3 pour les autres phases, et dans lequel la valeur de l'angle de la deuxième rotation dépend de l'indice $k_p$ de l'intensité mesurée, la valeur de l'angle de la deuxième rotation étant de préférence égale à $((k_p-1) \times 120°) - R$, où R représente la valeur de l'angle entre le vecteur de Fresnel de la première tension mesurée et l'axe de référence.

Ces caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un poste de transformation comprenant un premier tableau, un deuxième tableau connecté au premier tableau par l'intermédiaire d'un transformateur et un système de mesure d'au moins une grandeur électrique relative au deuxième tableau,
- la figure 2 est une représentation schématique du système de mesure de la figure 1, le système de mesure comprenant un module primaire de mesure de la tension, une pluralité de modules secondaires de mesure de l'intensité et un module de centralisation,
- la figure 3 est une représentation schématique du module secondaire de la figure 2,
- la figure 4 est une représentation de Fresnel des tensions et courants mesurés,
- la figure 5 est un organigramme des étapes d'un procédé de mesure, relatives à l'identification de la phase correspondant à chacune des tensions mesurées,
- la figure 6 est un organigramme des étapes du procédé de mesure relatives à l'identification de la phase correspondant à chacune des intensités mesurées, selon un premier mode de réalisation de l'invention, et
- la figure 7 est une vue analogue à celle de la figure 6 selon un deuxième mode de réalisation de l'invention.

Sur la figure 1, un poste de transformation 10 connecté à un réseau électrique 12 comprend un premier tableau 14, un deuxième tableau 16, un transformateur électrique 18 connecté entre le premier tableau et le deuxième tableau, et un système 20 de mesure d'au moins une grandeur électrique relative au deuxième tableau 16, telle que la valeur de la tension alternative et/ou du courant alternatif associé au deuxième tableau 16.

Le poste de transformation 10 est propre à transformer le courant électrique délivré par le réseau 12 et présentant une première tension alternative, en un courant électrique présentant une deuxième tension alternative.

Le réseau électrique 12 est un réseau moyenne tension, c'est-à-dire un réseau dont la tension est supérieure à 1 000 Volts et inférieure à 50 000 Volts. La première tension triphasée est alors une moyenne tension.

En variante, le réseau 12 est un réseau alternatif triphasé. Le réseau électrique 12 est un réseau haute tension, c'est-à-dire un réseau dont la tension est supérieure à 50 000 Volts. Autrement dit, la première tension triphasée est une haute tension.

En variante, le réseau électrique 12 est un réseau moyenne tension, c'est-à-dire un réseau dont la tension est supérieure à 1 000 Volts et inférieure à 50 000 Volts. La première tension triphasée est alors une moyenne tension.

Le premier tableau 14 comporte plusieurs arrivées 22, chaque arrivée 22 comportant un premier 24A, 24B, un deuxième 26A, 26B, et un troisième 28A, 28B conducteurs d'arrivée. Chaque premier, deuxième, troisième conducteur d'arrivée 24A, 24B, 26A, 26B, 28A, 28B est relié au réseau électrique par l'intermédiaire d'un disjoncteur d'arrivée 32 respectif. Le courant triphasé circulant dans les conducteurs d'arrivée 24A, 24B, 26A, 26B, 28A, 28B correspondants présente la première tension triphasée.

Le deuxième tableau 16 comprend un premier 34, un deuxième 36, un troisième 38 et un quatrième 39 conducteurs primaires et une pluralité N de départs 40A, 40B, ...40N, à savoir un premier départ 40A, un deuxième départ 40B, ..., un Nième départ 40N, chaque départ 40A, 40B, ..., 40N étant propre à délivrer une tension triphasée.

Chaque départ 40A, 40B, 40N est un départ basse tension, c'est-à-dire un départ dont la tension est inférieure à 1000 Volts. La deuxième tension triphasée est alors une basse tension.

En variante, chaque départ 40A, 40B, ..., 40N est un départ moyenne tension, c'est-à-dire un départ dont la tension est supérieure à 1000 Volts et inférieure à 50 000 Volts. Autrement dit, la deuxième tension triphasée est une moyenne tension.

Le premier départ 40A comporte un premier 42A, un deuxième 44A, un troisième 46A et un quatrième 48A conducteurs secondaires et trois disjoncteurs de départ 50. Les premier, deuxième et troisième conducteurs secondaires 42A, 42B, 42C sont respectivement reliés aux premier, deuxième et troisième conducteurs primaires 34, 36, 38 par l'intermédiaire d'un disjoncteur de départ 50 correspondant. Le quatrième conducteur secondaire 48A est directement connecté au quatrième conducteur primaire 39.

Les conducteurs primaires de départ 34, 36, 38 et les conducteurs secondaires de départ 42A, 44A, 46A correspondants présentent sensiblement la même tension, à savoir respectivement une première tension V1, une deuxième tension V2 et une troisième tension V3 correspondant aux trois phases de la deuxième tension triphasée. La tension triphasée des conducteurs primaires 34, 36, 38 et des conducteurs secondaires de départ 42A, 44A, 46A présente une fréquence $F_{tension}$ et une période $P_{tension}$.

Les autres départs 40B, ...40N sont identiques au premier départ 40A décrit précédemment, et comportent les mêmes éléments en remplaçant à chaque fois la lettre A par la lettre B, ..., N correspondante concernant les références des éléments.

Le transformateur électrique 18 est propre à transformer le courant issu du réseau électrique présentant la première tension alternative en le courant délivré au deuxième tableau 16 et présentant la deuxième tension alternative. Le transformateur électrique 18 comporte des enroulements primaires 52 connecté au premier tableau 14 et des enroulements secondaires 54 connecté au deuxième tableau 16.

Le système de mesure 20 est propre à mesurer la tension de chaque conducteur secondaire de départ 42A, 44A, 46A,... 46N.

En complément, le système de mesure 20 est propre à mesurer l'intensité du courant circulant dans chaque conducteur secondaire de départ 42A, 44A, 46A, ...46N.

Le système de mesure 20, visible sur la figure 2, comprend un module primaire 60, une pluralité N de modules secondaires 62A, 62B, ..., 62N, à savoir un premier module secondaire 62A, un deuxième module secondaire 62B, non représenté, ... et un Nième module secondaire 62N, et un module de centralisation 64. Chaque module secondaire 62A, ..., 62N est relié au module primaire 60 par une liaison de données correspondante, non représentée.

Le module primaire 60 comporte un organe 66 de mesure des tensions des conducteurs primaires 34, 36, 38 correspondant, et une unité 68 de traitement d'information. Le module primaire 60 comporte également un émetteur-récepteur radioélectrique 70, une antenne radioélectrique 72, lorsque les liaisons de données reliant le module primaire aux modules secondaires sont des liaisons radioélectriques, et un organe 74 d'alimentation électrique de l'organe de mesure, de l'unité de traitement d'information et de l'émetteur-récepteur radioélectrique.

En variante, le module primaire 60 comporte un émetteur-récepteur infrarouge lorsque les liaisons de données reliant le module primaire aux modules secondaires sont des liaisons infrarouges. En variante, le module primaire 60 comporte un émetteur-récepteur optique lorsque les liaisons de données reliant le module primaire aux modules secondaires sont des fibres optiques. En variante encore, le module primaire 60 comporte un émetteur-récepteur électrique lorsque les liaisons de données reliant le module primaire aux modules secondaires sont des paires torsadées ou des liaisons par courant porteur ou toutes autres liaisons galvaniquement isolées.

Le premier module secondaire 62A comporte, pour chacun des premier 42A, deuxième 44A et troisième 46A conducteurs secondaires, un capteur 76A de l'intensité du courant circulant dans le conducteur secondaire 42A, 44A, 46A correspondant. Le premier module secondaire 62A comporte une unité 78A de traitement d'information, un émetteur-récepteur radioélectrique 80A, et une antenne radioélectrique 82A lorsque la liaison de donnée reliant le premier module secondaire au module primaire est une liaison radioélectrique.

En variante, le premier module secondaire 62A comporte un émetteur-récepteur infrarouge lorsque la liaison de donnée reliant le premier module secondaire au module primaire est une liaison infrarouge. En variante, le premier module secondaire 62A comporte un émetteur-récepteur optique lorsque la liaison de donnée reliant le premier module secondaire au module primaire est une fibre optique. En variante encore, le module premier module secondaire 62A comporte un émetteur-récepteur électrique lorsque la liaison de donnée reliant le premier module secondaire au module primaire est une paire torsadée ou une liaison par courant porteur ou toute autre liaison galvaniquement isolée.

Le premier module secondaire 62A comporte également un organe 84A d'alimentation électrique de l'unité de traitement d'information et de l'émetteur-récepteur radioélectrique. Le premier module secondaire 62A est identifié par un numéro unique, également appelé identifiant.

Les autres modules secondaires 62B, ..., 62N sont identiques au premier module secondaire 62A décrit précédemment, et comportent les mêmes éléments en remplaçant à chaque fois la lettre A par la lettre B, ..., N correspondante concernant les références des éléments. Chacun des autres modules secondaires 62B, ..., 62N présente également un identifiant unique.

Le module de centralisation 64 comporte une unité 86 de traitement d'information, une base de données 88 et une interface homme-machine 90. Le module de centralisation 64 comporte un émetteur-récepteur radioélectrique 92, une antenne radioélectrique 94 et un organe 96 d'alimentation électrique de l'unité de traitement d'information, de la base de données, de l'interface homme-machine et de l'émetteur-récepteur radioélectrique.

L'organe de mesure 66 est propre à mesurer la première tension Va du premier conducteur primaire 34, la deuxième tension Vb du deuxième conducteur primaire 36 et la troisième tension Vc du troisième conducteur primaire 38. L'organe de mesure 66 est également propre à mesurer la fréquence $F_{tension}$ de la tension triphasée circulant à travers les conducteurs primaires 34, 36, 38.

L'unité de traitement d'informations 68 comporte un processeur 98 et une mémoire 100 apte à stocker une première application 101 d'identification de la phase correspondant à chaque tension mesurée Va, Vb, Vc.

La mémoire 100 est apte à stocker un premier logiciel 102 d'échantillonnage, sur la période $P_{tension}$ de la tension et avec une période d'échantillonnage $P_{ech}$ prédéterminée, de la valeur de la tension mesurée Va, Vb, Vc. Les échantillons de la tension mesurée Va, Vb, Vc sont notés respectivement $Va_m$, $Vb_m$, $Vc_m$ où m est un indice d'échantillons variant entre 1 et $N_{ech}$, $N_{ech}$ étant un nombre entier représentant le nombre d'échantillons de tension sur la période de tension $P_{tension}$ correspondant à une fréquence d'échantillonnage $F_{ech}$. $N_{ech}$ est également appelé nombre d'échantillons.

La mémoire 100 est apte à stocker un logiciel 103 d'association de manière prédéterminée de la première tension mesurée Va avec la première phase, de sorte que la tension mesurée Va est considérée égale à V1. La mémoire 100 est apte à stocker un premier logiciel 104 de détermination de K coefficient d'une transformée des échantillons $Va_m$, $Vb_m$, $Vc_m$ de chaque tension mesurée, K étant un nombre entier supérieur ou égal à 1.

La transformée est, par exemple, une transformée de Fourier, et le premier logiciel de détermination 104 est propre à calculer K coefficient(s) Re_k(Vj), Im_k(Vj) de la décomposition en série de Fourier des échantillons $Va_m$, $Vb_m$, $Vc_m$ de chaque tension mesurée Va, Vb, Vc, avec k compris entre 1 et K, et j respectivement égal à a, b et c.

Les coefficients Re_k(Vj) et Im_k(Vj) vérifient les équations suivantes, k étant compris entre 1 et K :

$$\mathrm{Re_k(Vj)} = \sum_{\mathrm{m=1}}^{\mathrm{N_{ech}}} \mathrm{Vj_m} \times \cos(2 \times \Pi \times \mathrm{F_{tension}} \times k \times m \times T) \quad (1)$$

$$\mathrm{Im_k(Vj)} = \sum_{\mathrm{m=1}}^{\mathrm{N_{ech}}} \mathrm{Vj_m} \times \sin(2 \times \Pi \times \mathrm{F_{tension}} \times k \times m \times T) \quad (2)$$

où T représente la période d'échantillonnage, également notée $P_{ech}$.

Les premiers coefficients Re_1(Vj) et Im_1(Vj) sont également appelés coefficients d'harmoniques et correspondent respectivement à l'abscisse et à l'ordonnée du vecteur de Fresnel de la tension mesurée Vj correspondante.

Le premier logiciel de détermination 104 forme alors un logiciel de détermination du vecteur de Fresnel de chacune des trois tensions mesurées.

Par la suite, les notations Va, Vb, Vc, V1, V2, V3 sont utilisées indifféremment pour la tension correspondante et pour le vecteur de Fresnel associé à cette tension.

La mémoire 100 est également apte à stocker un premier logiciel 105 de calcul d'un vecteur image Ph_θ1(Vj) via une première rotation du vecteur de Fresnel d'une tension parmi les deux tensions mesurées Vb, Vc autres que la première tension mesurée Va, j étant égal à b ou c. Le vecteur image Ph_θ1 (Vj) calculé à l'aide du premier logiciel de calcul 105 vérifie alors l'équation suivante :

$$\mathrm{Ph_}\theta 1(\mathrm{Vj}) = [\cos(\theta 1)\times \mathrm{Re(Vj)} - \sin(\theta 1)\times \mathrm{I}m(\mathrm{Vj})] + i\times[\cos(\theta 1)\times \mathrm{I}m(\mathrm{Vj}) + \sin(\theta 1)\times \mathrm{Re(Vj)}] \quad (3)$$

La mémoire 100 est également apte à stocker un premier logiciel 106 de comparaison de chaque vecteur image Ph_θ1(Vj) avec le vecteur de Fresnel de la première tension mesurée Va.

Le premier logiciel de détermination 104, le premier logiciel de calcul 105, et le premier logiciel de comparaison 106 forment la première application d'identification 101, la première application d'identification 101 étant propre à identifier la phase correspondant à chacune des deux autres tensions mesurées, la première tension mesurée étant associée à la première phase de manière prédéterminée par le logiciel d'association 103.

La mémoire 100 est apte à stocker un logiciel 107 d'émission d'un premier message M1 à destination de chaque module secondaire 62A, ... 62N et du module de centralisation 64, et un logiciel 108 de distribution d'un unique jeton aux modules secondaires 62A, ... 62N de manière successive.

La mémoire 100 est également apte à stocker un premier logiciel 109 d'indication de fin d'identification, propre à émettre un premier signal, tel qu'un premier signal lumineux, lorsque la première application d'identification 101 a identifié la phase correspondant à chacune des tensions mesurées.

Le premier message M1 contient notamment un signal permettant la synchronisation temporelle des échantillons de l'intensité mesurée via un capteur de courant 76A, ...76N correspondant par rapport aux échantillons de la tension mesurée, la période d'échantillonnage $P_{ech}$ et les coefficients Re_k(Vj), Im_k(Vj) des décompositions en série de Fourier des trois tensions Va, Vb, Vc jusqu'à l'harmonique K, calculées à l'aide du premier logiciel de détermination 104.

Deux méthodes possibles de synchronisation entre le module primaire et les modules secondaires sont décrites dans les demandes de brevet FR 11 57170 et respectivement FR 12 54796, déposées le 4 août 2011 et respectivement le 24 mai 2012 par le déposant de la présente demande. Cette synchronisation autorise le calcul de l'énergie électrique du courant circulant dans le conducteur secondaire 42A, 44A, 46A correspondant.

Le premier message M1 contient également l'identifiant du module secondaire qui sera autorisé à émettre son deuxième message à destination du module de centralisation 64 après la réception du premier message M1. L'identifiant du module secondaire autorisé à émettre ses informations de mesure est déterminé à l'aide du logiciel de distribution du jeton unique 108, l'identifiant du module contenu dans le premier message M1 permettant de désigner le module secondaire à qui l'unique jeton a été attribué.

L'émetteur-récepteur radioélectrique 70 est conforme au protocole de communication ZigBee basé sur la norme IEEE-802.15.4. En variante, l'émetteur-récepteur radioélectrique 70 est conforme à la norme IEEE-802.15.1, également appelée norme Bluetooth, ou à la norme IEEE-802.15.2. En variante encore, l'émetteur-récepteur radioélectrique 70 est conforme à la norme IEEE-802-11 également appelée norme WiFi, ou bien tout autre protocole radio propriétaire.

L'antenne radioélectrique 72 est adaptée pour émettre des signaux radioélectriques à destination des antennes 82A, ..., 82N des modules secondaires et de l'antenne 94 du module de centralisation, et également pour recevoir des signaux radioélectriques desdites antennes 82A, ..., 82N, 94. Autrement dit, le module primaire 60 est relié à chacun des modules secondaires 62A, ..., 62N et au module de centralisation 64 par une liaison radioélectrique correspondante.

L'organe d'alimentation 74 est propre à alimenter électriquement l'organe de mesure 66, l'unité de traitement d'information 68 et l'émetteur-récepteur radioélectrique 70 à partir de la tension triphasée circulant à travers les conducteurs primaires 34, 36, 38.

Chaque capteur de l'intensité 76A du premier module secondaire 62A est propre à mesurer une intensité respective parmi une première intensité I1A circulant dans le premier conducteur secondaire de départ 42A, une deuxième intensité I2A circulant dans le deuxième conducteur secondaire de départ 44A et une troisième intensité I3A circulant dans le troisième conducteur secondaire de départ 46A.

Chaque capteur de l'intensité 76A, également appelé capteur de courant, comporte un premier tore 110A disposé autour du conducteur secondaire de départ 42A, 44A, 46A correspondant et un premier enroulement 112A agencé autour du premier tore, comme représenté sur la figure 3. La circulation du courant à travers le conducteur secondaire de départ correspondant est propre à engendrer un courant induit proportionnel à l'intensité du courant dans le premier enroulement 112A. Le premier tore 110A est un tore de Rogowski. Le premier tore 110A est de préférence un tore ouvrant afin de faciliter son agencement autour des conducteurs correspondants.

Pour chaque capteur de courant 76A, la circulation du courant à travers le conducteur secondaire de départ correspondant est propre à engendrer un signal proportionnel à l'intensité du courant dans le premier enroulement 112A.

L'unité de traitement d'informations 78A visible sur la figure 2, comporte un processeur de données 114A, et une mémoire 116A associée au processeur de données et propre à stocker un second logiciel 118A d'échantillonnage, sur la période de tension $P_{tension}$, des valeurs des première, deuxième et troisième intensités IxA, IyA, IzA mesurées. Par souci de simplification, les intensités IxA, IyA, IzA sont notées par la suite Ix, Iy, Iz.

La mémoire 116A est apte à stocker un logiciel 119A de réception du premier message M1, un logiciel 120A de synchronisation temporelle de chaque capteur de courant 76A par rapport à l'organe de mesure de la tension 66. La mémoire 116A est apte à stocker un deuxième logiciel 121A de détermination de K coefficients de la transformée des échantillons $Ix_m$, $Iy_m$, $Iz_m$ de chaque intensité mesurée, K étant supérieur ou égal à 1. Dans le mode de réalisation décrit, la transformée est la transformée de Fourier, et le deuxième logiciel de détermination 121A est propre à calculer K coefficients Re_k(Ij), Im_k(Ij) de la décomposition en série de Fourier des échantillons $Ix_m$, $Iy_m$ $Iz_m$ de chaque intensité mesurée Ix, Iy, Iz, avec k compris entre 1 et K et j respectivement égal à x, y et z.

Les coefficients Re_k(Ij) et Im_k(Ij) vérifient les équations suivantes, k étant compris entre 1 et K :

$$\mathrm{Re_k(Ij)} = \sum_{m=1}^{N_{ech}} \mathrm{Ij}_m \times \cos(2 \times \Pi \times F_{tension} \times k \times m \times T) \quad (4)$$

$$\mathrm{Im_k(Ij)} = \sum_{m=1}^{N_{ech}} \mathrm{Ij}_m \times \sin(2 \times \Pi \times F_{tension} \times k \times m \times T) \quad (5)$$

où T représente la période d'échantillonnage, également notée $P_{ech}$.

Les premiers coefficients Re_1(Ij) et Im_1(Ij) sont également appelés coefficients d'harmoniques et correspondent respectivement à l'abscisse et à l'ordonnée du vecteur de Fresnel de l'intensité mesurée Vj correspondante.

Le deuxième logiciel de détermination 121A forme alors un logiciel de détermination du vecteur de Fresnel de chacune des trois intensités mesurées.

Par la suite, les notations Ix, Iy, Iz, I1, I2, I3 sont utilisées indifféremment pour l'intensité correspondante et pour le vecteur de Fresnel associé à cette intensité.

La mémoire 116 est apte à stocker un deuxième logiciel 122A de calcul de trois vecteurs image Ph_θ2(Ij) via une deuxième rotation des vecteurs de Fresnel des trois intensités mesurées Ix, Iy, Iz, j étant égal à x, y et z.

Les vecteurs image Ph_θ2(Ij) calculés à l'aide du deuxième logiciel de calcul 122A vérifient alors l'équation suivante :

$$Ph_\theta 2(Ij) = [\cos(\theta 2) \times Re(Ij) - \sin(\theta 2) \times Im(Ij)] + i \times [\cos(\theta 2) \times Im(Ij) + \sin(\theta 2) \times Re(Ij)] \quad (6)$$

La mémoire 116 est également apte à stocker un deuxième logiciel 124A de comparaison, avec un intervalle prédéterminé de valeurs angulaires, de la valeur de l'angle entre chaque vecteur image Ph_θ2(Ij) et un axe de référence X visible sur la figure 4.

Le deuxième logiciel de détermination 121A, le deuxième logiciel de calcul 122A, et le deuxième logiciel de comparaison 124A forment une deuxième application 125A d'identification de la phase correspondant à chacune des trois intensités mesurées Ix, Iy, Iz.

La mémoire 116 est également apte à stocker un deuxième logiciel 126A d'indication de fin d'identification, propre à émettre un deuxième signal, tel qu'un deuxième signal lumineux, lorsque la deuxième application d'identification 125A a identifié la phase correspondant à chacune des intensités mesurées.

La mémoire 116A est apte à stocker un logiciel 127A de calcul de l'énergie électrique $E_1$+, $E_1$-, $E_2$+, $E_2$-, $E_3$+, $E_3$- du courant circulant dans le conducteur secondaire 42A, 44A, 46A correspondant et un logiciel 128A d'émission d'un deuxième message M2A à destination du module de centralisation 64.

Le deuxième message M2A contient l'identifiant du premier module secondaire 62A, les valeurs d'énergies actives $E_1$+, $E_1$-, $E_2$+, $E_2$-, $E_3$+, $E_3$- pour l'ensemble des trois phases de la tension triphasée calculées par le logiciel de calcul 123A.

L'émetteur-récepteur radioélectrique 80A est du même type que l'émetteur-récepteur radioélectrique 70.

L'antenne radioélectrique 82A, du même type que l'antenne radioélectrique 72, est adaptée pour recevoir des signaux radioélectriques de l'antenne 72 du module primaire et de l'antenne 94 du module de centralisation et également pour émettre des signaux radioélectriques aux antennes 72, 94.

L'organe d'alimentation 84A, visible sur la figure 3, est propre à alimenter l'unité de traitement d'information 78A et l'émetteur-récepteur radioélectrique 80A. L'organe d'alimentation 84A comporte, pour chacun des premier 42A, deuxième 44A et troisième 46A conducteurs secondaires, un deuxième tore 130A disposé autour du conducteur secondaire 42A, 44A, 46A correspondant et un deuxième enroulement 132A agencé autour du deuxième tore. La circulation du courant dans le conducteur secondaire 42A, 44A, 46A correspondant est propre à engendrer un courant induit dans le deuxième enroulement 132A.

L'organe d'alimentation 84A comporte un convertisseur 134A connecté à chacun des deuxièmes enroulements 132A et propre à délivrer une tension prédéterminée à l'unité de traitement d'information 78A et à l'émetteur-récepteur radioélectrique 80A. Chaque deuxième tore 130A est un tore en fer. Chaque deuxième tore 130A est de préférence un tore ouvrant afin de faciliter son agencement autour des conducteurs correspondants.

Autrement dit, le module secondaire 62A est autoalimenté par l'intermédiaire de l'organe d'alimentation 84A comportant les deuxièmes tores 130A adaptés pour récupérer l'énergie magnétique issue de la circulation du courant dans les conducteurs secondaires 42A, 44A, 46A correspondants.

Les éléments des autres modules secondaires 62B, ..., 62N, et respectivement les deuxièmes messages M2B, ..., M2N, sont identiques aux éléments du premier module secondaire 62A, et respectivement au deuxième message M2A, décrits précédemment, et comportent les mêmes sous-éléments en remplaçant à chaque fois la lettre A par la lettre B, ..., N correspondante concernant les références des sous-éléments.

L'unité de traitement d'information 86 du module de centralisation, visible sur la figure 2, comporte un processeur de données 136, et une mémoire 138 associée au processeur et apte à stocker un logiciel 140 de réception des premier et deuxièmes messages M1, M2A,..., M2N, un logiciel 142 d'enregistrement dans la base de données 88 des informations contenues dans les messages M1, M2A,..., M2N reçus. La mémoire 138 est propre à stocker un logiciel 144 de traitement desdites informations reçues, un logiciel 146 d'affichage de données et un logiciel 148 de transmission de données à destination d'un serveur distant, non représenté.

L'interface homme-machine 90 comporte un écran d'affichage et un clavier de saisie, non représentés. En variante, l'interface homme-machine 90 comporte un écran tactile et la saisie de données est réalisée par l'intermédiaire de touches tactiles affichées à l'écran. En variante, l'interface homme-machine est déportée sur un téléphone portable, une tablette informatique ou un ordinateur portable via une liaison radio, telle qu'une liaison conforme à la norme WiFi, une liaison conforme à la norme Bluetooth, une liaison en champ proche, également appelée liaison NFC (de l'anglais *Near Field Communication*), ou encore une liaison de radio-identification, également appelée liaison RFID (de l'anglais *Radio Frequency IDentification).*

L'émetteur-récepteur radioélectrique 92 est du même type que les émetteurs-récepteurs radioélectriques 70, 80A, ..., 80N.

L'antenne radioélectrique 94, du même type que les antennes radioélectriques 72, 82A, ..., 82N, est propre à recevoir des signaux radioélectriques issus de l'antenne 72 du module primaire et des antennes 82A, ..., 82N des modules secondaires et également à émettre des signaux radioélectriques à destination desdites antennes 72, 82A, ..., 82N.

Le fonctionnement du système de mesure 20 va désormais être expliqué à l'aide des figures 5 et 6.

Les étapes, visibles sur la figure 5, du procédé de mesure mises en oeuvre par le module primaire 60 pour l'identification de la phase correspondant à chacune des trois tensions mesurées Va, Vb, Vc vont être à présent décrites.

Lors de la première étape 150, le module primaire 60 s'initialise et mesure la fréquence $F_{tension}$ de la tension triphasée des conducteurs primaires 34, 36, 38. La fréquence $F_{tension}$ de la tension triphasée est égale à la fréquence du réseau, telle que 50 Hz par exemple en Europe et 60 Hz par exemple aux Etats-Unis.

Lors de cette première étape 150, le module primaire 60 mesure ensuite les première, deuxième et troisième tensions Va, Vb, Vc à l'aide de son organe de mesure 66 et échantillonne les valeurs mesurées des tensions Va, Vb, Vc à l'aide de son premier logiciel d'échantillonnage 102.

La fréquence d'échantillonnage $F_{ech}$ est un multiple de la fréquence $F_{tension}$ de la tension triphasée égale à l'inverse de la période $P_{tension}$ de ladite tension triphasée mesurée précédemment. La période $P_{tension}$ de la tension triphasée est égale à la période du réseau, soit environ 20ms en Europe et environ 16,66 ms aux Etats-Unis.

Dans le mode de réalisation décrit, la fréquence d'échantillonnage $F_{ech}$ présente, par exemple, une valeur égale à 7200 Hz et le nombre d'échantillons $N_{ech}$ par période de 20 ms est alors égal à 144.

Lors de l'étape 150, afin d'optimiser la précision de la mesure de l'énergie, la période $P_{tension}$ de la tension est mesurée régulièrement, telle que toutes les dix secondes, afin de prendre en compte des variations dans le temps de celle-ci.

Lors de l'étape suivante 155, le logiciel d'association 103 associe de manière prédéterminée la première tension mesurée Va avec la première phase. Autrement dit, la première tension mesurée Va est supposée égale à la tension V1.

Le premier logiciel de détermination 104 détermine ensuite, lors de l'étape suivante 160, le ou les premiers coefficients Re_k(Vj) et Im_k(Vj) de chacune des tensions mesurées Va, Vb, Vc à l'aide des équations (1) et (2), où j est égal à a, b, ou c et k est compris entre 1 et K.

Lors de cette étape 160, le premier logiciel de calcul 105 calcule, à l'aide de l'équation (3), le vecteur image Ph_θ1(Vj) via la première rotation du vecteur de Fresnel d'une parmi les deux autres tensions mesurées, où θ1 désigne l'angle de la première rotation. En associant un indice $k_p$ à chaque phase à identifier, l'indice $k_p$ étant un nombre entier égal à 1 pour la première phase et prenant les valeurs entières égales à 2 ou 3 pour les deux autres phases, la valeur de l'angle θ1 de la première rotation dépend de l'indice $k_p$ de la phase à identifier.

La valeur, exprimée en degrés, de l'angle θ1 de la première rotation est, par exemple, définie par l'équation suivante :

$$\theta 1 = (k_p - 1) \times 120° \qquad (7)$$

Le premier dispositif d'identification 101 cherche tout d'abord à identifier la tension mesurée correspondant à la deuxième phase, la tension mesurée correspondant à la troisième phase étant ensuite identifiée par déduction. Le premier logiciel de calcul 105 calcule alors le vecteur image Ph_120(Vj) via la première rotation du vecteur de Fresnel d'une parmi les deux autres tensions mesurées, telles que le vecteur image correspondant à la deuxième tension mesurée Vb. L'indice $k_p$ associé à la deuxième phase à identifier est égal à 2, et l'angle θ1 de la première rotation est alors égal à 120°.

Après la rotation de 120° du vecteur de Fresnel Vb de la deuxième tension mesurée, le premier logiciel de comparaison 106 compare le vecteur image Ph_120(Vb) obtenu avec le vecteur de Fresnel V1 de la première tension mesurée. La comparaison consiste, par exemple, à comparer les premiers coefficients de la décomposition en série de Fourier du vecteur image Ph_120(Vb) avec les premiers coefficients correspondants du vecteur de Fresnel V1 de la première tension mesurée selon les inéquations suivantes :

$$\mathrm{Re_1}(V1) - C1 \times Mod(V1) < \mathrm{Re_1(Ph_120(Vb))} < \mathrm{Re_1}(V1) + C1 \times Mod(V1) \qquad (8)$$

$$\mathrm{Im_1}(V1) - C1 \times Mod(V1) < \mathrm{Im_1(Ph_120(Vb))} < \mathrm{Im_1}(V1) + C1 \times Mod(V1) \qquad (9)$$

où C1 est un premier facteur, et

Mod(V1) représente le module du vecteur de Fresnel V1 de la première tension mesurée.

D'après les inéquations (8) et (9), la comparaison entre le vecteur image Ph_120(Vb) et le vecteur de Fresnel V1 de la première tension mesurée est effectuée avec une première tolérance d'erreur égale à C1 fois le module du vecteur de Fresnel de la première tension mesurée V1 à la fois en abscisse et en ordonnée.

Dans le mode de réalisation décrit, le premier facteur C1 est égal 0,1, la première tolérance d'erreur correspond à une première tolérance angulaire de l'ordre de +/- 6° à +/-8°.

Si les inéquations (8) et (9) sont respectées, c'est-à-dire si la rotation de 120° du vecteur de Fresnel Ph_120(Vb) de la deuxième tension mesurée est sensiblement confondue avec le vecteur de Fresnel V1 de la première tension mesurée, alors le premier logiciel de comparaison 106 considère lors de l'étape 165 que la deuxième tension mesurée Vb correspond à la deuxième phase, et par déduction que la troisième tension mesurée Vc correspond à la troisième phase. Autrement dit, Vb est égal à V2 et Vc est égal à V3.

Le premier logiciel d'indication 109 signale enfin lors de l'étape 170 le repérage correct des sondes de tension en émettant un premier signal, tel qu'un premier signal lumineux à l'aide de diodes électroluminescentes, non représentées, afin d'indiquer que la première application d'identification 101 a identifié la phase correspondant à chacune des tensions mesurées Va, Vb, Vc.

Si, lors de l'étape 160, le résultat de la comparaison selon les inéquations (8) et (9), entre le vecteur image Ph_120(Vb) de Vb par rotation de 120° et le vecteur de Fresnel V1 de la première tension mesurée est négatif, alors le premier logiciel de calcul 105 calcule, de manière analogue, lors de l'étape 175, le vecteur image Ph_120(Vc) via la première rotation de 120° du vecteur de Fresnel Vc de la troisième tension mesurée, et le premier logiciel de comparaison 106 compare de manière analogue le vecteur image obtenu Ph_120(Vc) avec le vecteur de Fresnel V1 de la première tension mesurée selon les inéquations suivantes :

$$\mathrm{Re_1}(V1) - C1 \times Mod(V1) < \mathrm{Re_1}(\mathrm{Ph_120(Vc)}) < \mathrm{Re_1}(V1) + C1 \times Mod(V1) \quad (10)$$

$$\mathrm{Im_1}(V1) - C1 \times Mod(V1) < \mathrm{Im_1}(\mathrm{Ph_120(Vc)}) < \mathrm{Im_1}(V1) + C1 \times Mod(V1) \quad (11)$$

Si le résultat de la comparaison est positif, c'est-à-dire si la rotation de 120° du vecteur de Fresnel Vc de la troisième tension mesurée est égale, à la première tolérance d'erreur près, au vecteur de Fresnel V1 de la première tension mesurée, alors le premier logiciel de comparaison 106 considère, lors de l'étape 180, que la troisième tension mesurée Vc correspond à la deuxième phase, et par déduction, que la deuxième tension mesurée Vb correspond à la troisième phase. Autrement dit, Vc est égal à V2 et Vb est égal à V3.

A l'issue de l'étape 180, le procédé passe, de manière analogue, à l'étape 170, afin que le premier logiciel d'indication 109 signale le repérage correct de l'ensemble des sondes de tension, c'est-à-dire que la première application d'identification 101 a identifié la phase correspondant à chacune des tensions mesurées Va, Vb, Vc.

Si le résultat de la comparaison effectuée lors de l'étape 175 est négatif, alors le procédé retourne à l'étape 150.

Ceci est également susceptible de se produire dans le cas d'un déphasage relativement important entre les différentes tensions mesurées Va, Vb, Vc, de sorte qu'après rotation du vecteur de Fresnel de l'une des autres tensions mesurées Vb, Vc, le vecteur image obtenu Ph_120(Vb), Ph_120(Vc) n'est pas égal, à la première tolérance d'erreur près, au vecteur de Fresnel V1 de la première tension mesurée. Ceci est également susceptible de se produire en cas de différence importante des amplitudes des tensions Va, Vb et Vc.

Le module primaire 60 émet périodiquement le premier message M1 à destination de chacun des modules secondaires 62A, ... 62N et du module de centralisation 64. La période d'émission $P_{émission}$ est prédéterminée, et de préférence égale à 1 seconde. Le premier message M1 est ainsi émis toutes les secondes.

Après l'émission du premier message M1, le module primaire 60 mesure à nouveau la tension Va, Vb, Vc des conducteurs primaires 34, 36, 38.

Les étapes, visibles sur la figure 6, du procédé de mesure mises en oeuvre par les modules secondaires 62A, ...62N pour l'identification de la phase correspondant à chacune des trois intensités mesurées Ix, Iy, Iz vont être à présent décrites pour le premier module secondaire 62A.

Lors de l'étape 200, le premier module secondaire 62A s'initialise et ouvre une fenêtre glissante de réception du premier message M1 à l'aide de son logiciel de réception 119A. La fenêtre de réception est une fenêtre présentant une durée de quelques dizaines de millisecondes que le premier module secondaire 62A fait glisser dans le temps.

Lors de la réception du premier message M1, le premier module secondaire 62A vérifie que le premier message M1 contient le signal de synchronisation et le logiciel de synchronisation 120A initialise alors, à la date de réception du premier message M1, un compteur destiné à s'incrémenter jusqu'à une valeur correspondant à la période d'émission du premier message $P_{émission}$. Le module secondaire 62A retourne alors automatiquement à l'étape de réception 200 environ une milliseconde avant la réception attendue du prochain premier message M1. Le logiciel de synchronisation 120A effectue également la resynchronisation de l'échantillonnage à l'aide de la valeur de la période d'échantillonnage $P_{ech}$ contenue dans le premier message M1 et de la date de réception du premier message M1.

La date de réception du premier message M1 est la date de référence pour la synchronisation du premier module secondaire 62A par rapport au module primaire 60, et plus précisément pour la synchronisation de la mesure des intensités IxA, IyA, IzA, notées par la suite Ix, Iy, Iz, par rapport à la mesure des tensions Va, Vb, Vc.

Si le premier message M1 n'est pas détecté par le premier module secondaire 62A, la fenêtre de réception est refermée et aucune synchronisation n'est effectuée.

Le premier module secondaire 62A mesure ensuite, lors de cette étape 200 et par l'intermédiaire de ses capteurs de courant 76A, chacune des première, deuxième et troisième intensités Ix, Iy, Iz. Le deuxième logiciel d'échantillonnage 118A échantillonne en outre les valeurs mesurées des trois intensités Ix, Iy, Iz, l'instant de début de l'échantillonnage ayant été réinitialisé précédemment afin d'assurer la synchronisation temporelle du capteur de l'intensité 76A par rapport à l'organe de mesure de la tension 66.

Lors de l'étape 210, le deuxième logiciel de détermination 121A commence par déterminer, à l'aide des équations (4) et (5), le ou les premiers coefficients Re_k(Ij) et Im_k(Ij) de chacune des intensités mesurées Ix, Iy, Iz, où j est égal à x, y, z, et k est compris entre 1 et K.

Le deuxième logiciel de calcul 122A détermine ensuite un déphasage R de la première tension mesurée V1, c'est-à-dire l'angle entre le vecteur de Fresnel V1 de la première tension mesurée et l'axe de référence X, à l'aide des équations suivantes :

$$\text{Si Re_1(V1)>0, alors } R = \arctan\left(\frac{\text{Im_1}(V1)}{\text{Re_1}(V1)}\right) \qquad (12)$$

$$\text{Si Re_1(V1)<0, alors } R = 180° + \arctan\left(\frac{\text{Im_1}(V1)}{\text{Re_1}(V1)}\right) \qquad (13)$$

Lors des étapes 220 à 260, le deuxième logiciel de calcul 122A calcule successivement les vecteurs image Ph_θ2(Ij) via la deuxième rotation des vecteurs de Fresnel des intensités mesurées à l'aide de l'équation (6), où θ2 désigne l'angle de la deuxième rotation. La valeur de l'angle θ2 de la deuxième rotation dépend de l'indice $k_p$ de la phase à identifier.

La valeur, exprimée en degrés, de l'angle θ2 de la deuxième rotation est, par exemple, définie par l'équation suivante :

$$\theta 2 = (k_p - 1) \times 120° - R \qquad \text{avec } k_p \text{ égal à 1, 2 ou 3} \qquad (14)$$

La deuxième application d'identification 125A cherche tout d'abord, lors des étapes 220 et 230, à identifier l'intensité mesurée correspondant à la première phase. Le deuxième logiciel de calcul 122A calcule alors un vecteur image Ph_S(Ij) via la deuxième rotation du vecteur de Fresnel de l'intensité mesurée Ij, tel que le vecteur image Ph_S(Ix) correspondant à la première intensité mesurée Ix, où S est égal à -R. L'indice $k_p$ associé à la première phase à identifier est égal à 1, et l'angle θ2 de la deuxième rotation est alors égal à -R, soit S.

Après la rotation de S du vecteur de Fresnel Ij de l'intensité mesurée, le deuxième logiciel de comparaison 124A compare l'angle entre le vecteur image Ph_S(Ij) obtenu et l'axe de référence X avec un intervalle prédéterminé de valeurs angulaires compris entre une première valeur négative $-\alpha 1_{ref}$ et une deuxième valeur positive $\alpha 2_{ref}$. La comparaison consiste, par exemple, à comparer les valeurs des tangentes de ces différents angles selon l'inéquation suivante :

$$-\tan(\alpha 1_{ref}) < \frac{\text{Im_1(Ph_S(Ij))}}{\text{Re_1(Ph_S(Ij))}} < \tan(\alpha 2_{ref}) \qquad (15)$$

Dans l'exemple de réalisation de la figure 6, la première valeur négative $-\alpha 1_{ref}$ est égale à -30° et la deuxième valeur positive $\alpha 2_{ref}$ est égale à +30°.

Si l'inéquation (15) est vérifiée par la première intensité mesurée Ix, i.e. pour j égal à x, alors le deuxième logiciel de comparaison 124A considère lors de l'étape 230 que la première intensité mesurée correspond à la première phase, c'est-à-dire que Ix est égal à I1, et passe à l'étape 240.

Sinon, le deuxième logiciel de calcul 122A poursuit l'étape 220 en calculant le vecteur image Ph_S(Iy) correspondant à la deuxième intensité mesurée Iy, puis compare, de manière analogue à l'aide de l'inéquation (15), l'angle entre le vecteur image Ph_S(Iy) et l'axe de référence X avec l'intervalle prédéterminé de valeurs angulaires $]-\alpha 1_{ref} ; \alpha 2_{ref}[$.

Si l'inéquation (15) est vérifiée par la deuxième intensité mesurée Iy, alors le deuxième logiciel de comparaison 124A considère lors de l'étape 230 que la deuxième intensité mesurée correspond à la première phase, c'est-à-dire que Iy est égal à I1, et passe à l'étape 240.

Sinon, le deuxième logiciel de calcul 122A poursuit l'étape 220 en calculant le vecteur image Ph_S(Iz) correspondant à la troisième intensité mesurée Iz, puis compare, de manière analogue à l'aide de l'inéquation (15), l'angle entre le vecteur image Ph_S(Iz) et l'axe de référence X avec l'intervalle prédéterminé de valeurs angulaires ]-$\alpha 1_{ref}$ ; $\alpha 2_{ref}$[.

Si l'inéquation (15) est vérifiée par la troisième intensité mesurée Iz, alors le deuxième logiciel de comparaison 124A considère lors de l'étape 230 que la troisième intensité mesurée correspond à la première phase, c'est-à-dire que Iz est égal à I1, et passe à l'étape 240.

Sinon, le deuxième logiciel de calcul 122A passe également à l'étape 240 étant donné que l'identification avec la première phase a été testée pour toutes les intensités mesurées Ix, Iy, Iz.

La deuxième application d'identification 125A cherche alors, lors des étapes 240 et 250, à identifier de manière analogue l'intensité mesurée correspondant à la deuxième phase. Le deuxième logiciel de calcul 122A calcule alors un vecteur image Ph_120(Ph_S(Ij)) via la deuxième rotation du vecteur de Fresnel de l'intensité mesurée Ij, successivement pour les première, deuxième et troisième intensités mesurées Ix, Iy, Iz, jusqu'au moment où l'intensité mesurée correspondant à la deuxième phase a été identifiée ou bien jusqu'à avoir testé toutes les intensités mesurées Ix, Iy, Iz.

L'indice $k_p$ associé à la deuxième phase à identifier est égal à 2, et l'angle $\theta 2$ de la deuxième rotation est alors égal à 120°-R, soit 120°+S. L'homme du métier remarquera que Ph_120(Ph_S(Ij)) est égal à Ph_(120+S)(Ij).

Après chaque rotation de 120°+S du vecteur de Fresnel de l'intensité mesurée Ij, le deuxième logiciel de comparaison 124A compare l'angle entre le vecteur image Ph_120(Ph_S(Ij)) obtenu et l'axe de référence X avec l'intervalle prédéterminé de valeurs angulaires ]-$\alpha 1_{ref}$ ; $\alpha 2_{ref}$[.

La comparaison consiste, par exemple, à comparer les valeurs des tangentes de ces différents angles selon l'inéquation suivante :

$$-\tan(\alpha 1_{ref}) < \frac{\mathrm{Im_1(Ph_120(Ph_S(Ij)))}}{\mathrm{Re_1(Ph_120(Ph_S(Ij)))}} < \tan(\alpha 2_{ref}) \qquad (16)$$

Si l'inéquation (16) est vérifiée par ladite intensité mesurée Ij, alors le deuxième logiciel de comparaison 124A considère lors de l'étape 250 que ladite intensité mesurée Ij correspond à la deuxième phase, c'est-à-dire que Ij est égal à I2, et passe à l'étape 260.

Sinon, le deuxième logiciel de calcul 122A poursuit l'étape 240 en calculant le vecteur image Ph_120(Ph_S(Ij)) correspondant à l'intensité mesurée suivante, puis compare, de manière analogue à l'aide de l'inéquation (16), l'angle entre le vecteur image Ph_120(Ph_S(Ij)) et l'axe de référence X, avec l'intervalle prédéterminé de valeurs angulaires ]-$\alpha 1_{ref}$ ; $\alpha 2_{ref}$[.

Si l'inéquation (16) est vérifiée par la troisième intensité mesurée Iz, alors le deuxième logiciel de comparaison 124A considère lors de l'étape 250 que la troisième intensité mesurée correspond à la deuxième phase, c'est-à-dire que Iz est égal à I2, et passe à l'étape 260.

Sinon, le deuxième logiciel de calcul 122A passe également à l'étape 260 étant donné que l'identification avec la deuxième phase a été testée pour toutes les intensités mesurées Ix, Iy, Iz.

La deuxième application d'identification 125A cherche enfin, lors des étapes 260 et 270, à identifier de manière analogue l'intensité mesurée correspondant à la troisième phase. Le deuxième logiciel de calcul 122A calcule alors un vecteur image Ph_120(Ph_120(Ph_S(Ij))) via la deuxième rotation du vecteur de Fresnel de l'intensité mesurée Ij, successivement pour les première, deuxième et troisième intensités mesurées Ix, Iy, Iz, jusqu'au moment où l'intensité mesurée correspondant à la troisième phase a été identifiée ou bien jusqu'à avoir testé toutes les intensités mesurées Ix, Iy, Iz.

L'indice $k_p$ associé à la troisième phase à identifier est égal à 3, et l'angle $\theta 2$ de la deuxième rotation est alors égal à 240°-R, soit 240°+S. L'homme du métier remarquera que Ph_120(Ph_120(Ph_S(Ij))) est égal à Ph_(240+S)(Ij).

Après chaque rotation de 240°+S du vecteur de Fresnel de l'intensité mesurée Ij, le deuxième logiciel de comparaison 124A compare l'angle entre le vecteur image Ph_120(Ph_120(Ph_S(Ij))) obtenu et l'axe de référence X avec l'intervalle prédéterminé de valeurs angulaires ]-$\alpha 1_{ref}$ ; $\alpha 2_{ref}$[.

La comparaison consiste, par exemple, à comparer les valeurs des tangentes de ces différents angles selon l'inéquation suivante :

$$-\tan(\alpha 1_{ref}) < \frac{\mathrm{Im_1(Ph_120(Ph_120(Ph_S(Ij))))}}{\mathrm{Re_1(Ph_120(Ph_120(Ph_S(Ij))))}} < \tan(\alpha 2_{ref}) \qquad (17)$$

Si l'inéquation (17) est vérifiée par ladite intensité mesurée Ij, alors le deuxième logiciel de comparaison 124A considère lors de l'étape 270 que ladite intensité mesurée Ij correspond à la troisième phase, c'est-à-dire que Ij est égal à I3, et passe à l'étape 275.

Sinon, le deuxième logiciel de calcul 122A poursuit l'étape 260 en calculant le vecteur image Ph_120(Ph_120(Ph_S(Ij))) correspondant à l'intensité mesurée suivante, puis compare, de manière analogue à l'aide de l'inéquation (17), l'angle entre le vecteur image Ph_120(Ph_120(Ph_S(Ij))) et l'axe de référence X, avec l'intervalle prédéterminé de valeurs angulaires ]-$\alpha 1_{ref}$ ; $\alpha 2_{ref}$[.

Si l'inéquation (17) est vérifiée par la troisième intensité mesurée Iz, alors le deuxième logiciel de comparaison 124A considère lors de l'étape 270 que la troisième intensité mesurée correspond à la troisième phase, c'est-à-dire que Iz est égal à I3, et passe à l'étape 275.

Sinon, le deuxième logiciel de calcul 122A passe également à l'étape 275 étant donné que l'identification avec la troisième phase a été testée pour toutes les intensités mesurées Ix, Iy, Iz.

La deuxième application d'identification 125A teste, lors de l'étape 275, si toutes les intensités mesurées Ix, Iy, Iz ont été identifiées à une phase respective, et le cas échéant passe à l'étape 280.

Lors de l'étape 280, le deuxième logiciel d'indication 126A signale le repérage correct des capteurs de courant 76A en émettant un deuxième signal, tel qu'un deuxième signal lumineux à l'aide de diodes électroluminescentes, non représentées, afin d'indiquer que la deuxième application d'identification 125A a identifié la phase correspondant à chacune des intensités mesurées Ix, Iy, Iz.

Chaque capteur de courant 76A comporte, par exemple, une diode électroluminescente, non représentée, et le deuxième signal lumineux est en forme d'un flash de diode pour la première phase, en forme de deux flashs pour la deuxième phase et de trois flashs pour la troisième phase.

Si toutes les intensités mesurées Ix, Iy, Iz n'ont pas été identifiées à une phase respective, alors la deuxième application d'identification 125A teste, lors de l'étape 285, si au moins deux intensités mesurées Ix, Iy, Iz ont été identifiées à une phase respective, et le cas échéant passe à l'étape 290. Sinon, la deuxième application d'identification 125A retourne à l'étape 200.

Lors de l'étape 290, la deuxième application d'identification 125A identifie par déduction la phase correspondant à l'intensité mesurée qui n'a pas été identifiée, sachant que les phases ont été identifiées pour toutes les autres intensités mesurées. Elle passe ensuite à l'étape 280, afin que le repérage correct des capteurs de courant 76A soit signalé.

Après identification des phases, le logiciel de calcul 127A calcule également de manière périodique l'énergie active $E_1$-, $E_2$+, $E_2$-, $E_3$+, $E_3$- pour chacune des trois phases à partir des valeurs des tensions V1, V2, V3 mesurées et identifiées, ainsi que des valeurs des intensités I1A, I2A, I3A mesurées par les capteurs de courant 76A et identifiées. La période de calcul des énergies actives $E_1$, $E_2$, $E_3$ est égale à la période $P_{tension}$, soit par exemple 20 ms.

Les variations des tensions V1, V2, V3 sont suffisamment limitées entre deux instants d'émission du premier message M1, c'est-à-dire sur une période d'une seconde, pour permettre le calcul des énergies actives $E_1$-, $E_2$+, $E_2$-, $E_3$+, $E_3$- toutes les 20 ms, à partir des valeurs des intensités I1A, I2A, I3A mesurées toutes les 20 ms et des valeurs des tensions V1, V2, V3 reçues toutes les secondes.

Pour le calcul des énergies actives $E_1$-, $E_2$+, $E_2$-, $E_3$+, $E_3$-, le logiciel de calcul 127A calcule, à chaque période $P_{tension}$, une puissance active $P_j$ de chaque phase numéro j, j étant égal à 1, 2 ou 3, à l'aide des équations suivantes :

$$P_{j,k} = \frac{\left[\mathrm{Re}_k(Vj) \times \mathrm{Re}_k(IjA) + \mathrm{Im}_k(Vj) \times \mathrm{Im}_k(IjA)\right]}{2} \quad (18)$$

où k est compris entre 1 et K

$$P_j = \sum_{k=1}^{K} P_{j,k} \quad (19)$$

Le logiciel de calcul 127A détermine également, à chaque période $P_{tension}$, la puissance réactive $Q_j$ de chaque phase numéro j, j étant égal à 1, 2 ou 3, à l'aide des équations suivantes :

$$Q_{j,k} = \frac{\left[\mathrm{Im}_k(Vj) \times \mathrm{Re}_k(IjA) - \mathrm{Re}_k(Vj) \times \mathrm{Im}_k(IjA)\right]}{2} \quad (20)$$

où k est compris entre 1 et K

$$Q_j = \sum_{k=1}^{K} Q_{j,k} \quad (21)$$

A chaque période $P_{tension}$, une première énergie active Ej+ est incrémentée uniquement lorsque $P_{j,1}$ est positif, c'est-à-dire que la puissance correspondant au produit du fondamental du courant et du fondamental de la tension est positive, ce qui correspond à une puissance consommée par une charge en aval du système de mesure.

Un incrément de la première énergie active ΔEj+ est alors égal au produit de la période $P_{tension}$ avec la puissance active $P_{j,1}$ calculée sur la dernière période, suivant l'équation suivante :

$$\Delta E_{j+} = P_{tension} \times P_{j,1} \quad \text{avec} \quad P_{j,1} > 0 \quad (22)$$

A chaque période $P_{tension}$, une deuxième énergie active Ej- est incrémentée uniquement lorsque $P_{j,1}$ est négatif, c'est-à-dire que la puissance correspondant au produit du fondamental du courant et du fondamental de la tension est négative, ce qui correspond à une puissance fournie par un générateur en aval du système de mesure.

Un incrément de la deuxième énergie active ΔEj- est alors égal au produit de la période $P_{tension}$ avec la puissance active $P_{j,1}$ calculée sur la dernière période, suivant l'équation suivante :

$$\Delta E_{j-} = P_{tension} \times P_{j,1} \quad \text{avec} \quad P_{j,1} < 0 \quad (23)$$

Pour un réseau électrique triphasé, le système de mesure 20 incrémente donc en permanence six compteurs d'énergie : $E_1$+, $E_1$-, $E_2$+, $E_2$-, $E_3$+, $E_3$-. Ainsi les énergies produites et consommées sont bien distinctes. Le système de mesure 20 est également adapté pour mesurer l'énergie fournie par des générateurs d'énergie répartis sur le réseau électrique.

Le premier module secondaire 62A élabore alors son deuxième message M2A. Le deuxième message M2A contient l'identifiant du premier module secondaire 62A, les valeurs des six compteurs d'énergie $E_1$+, $E_1$-, $E_2$+, $E_2$-, $E_3$+, $E_3$- pour l'ensemble des trois phases de la tension triphasée et les coefficients complexes Re_k(IjA), Im_k(IjA) de la décomposition en série de Fourier des trois courants I1A, I2A, I3A jusqu'à l'harmonique K.

En complément, le deuxième message M2A contient les valeurs des moyennes quadratiques, également notées RMS, des courants I1A, I2A, I3A des trois phases, ainsi que les termes $P_{j,1}$ et $Q_{j,1}$ pour chacune des trois phases, et les valeurs $P_j$ et $Q_j$ pour chacune des trois phases.

Dans l'hypothèse où l'identifiant du premier module secondaire 62A était contenu dans le premier message M1 reçu précédemment, le premier module secondaire 62A émet alors son deuxième message M2A à l'aide de son logiciel d'émission 128A. Dans le cas contraire, le premier module secondaire 62A retourne directement à l'étape de réception du premier message M1, et émettra son deuxième message M2A lorsque le premier message M1 contiendra son identifiant indiquant alors que l'unique jeton lui aura été attribué afin de l'autoriser à émettre son deuxième message M2A.

Les étapes du procédé de mesure mises en oeuvre par les autres modules secondaires 62B, ..., 62N sont identiques aux étapes 200 à 290 décrites précédemment pour le premier module secondaire 62A, et sont réalisées en outre de manière simultanée entre tous les modules secondaires 62A, ..., 62N de par la synchronisation temporelle effectuée à l'aide du premier message M1.

Le module de centralisation 64 reçoit, à l'aide de son logiciel de réception 140, le premier message M1 du module primaire 60 et le deuxième message du module secondaire autorisé à émettre selon le mécanisme de jeton distribué, par exemple le message M2A.

Le module de centralisation 64 enregistre ensuite dans sa base de données 88 les valeurs reçues et contenues dans le premier message M1 et dans le deuxième message M2A, par l'intermédiaire de son logiciel d'enregistrement 142. En complément, le logiciel de traitement 144 effectue un horodatage des données enregistrées.

En complément, le logiciel de traitement 144 calcule certaines grandeurs électriques, telles que le facteur de puissance $\cos(\varphi_j)$ pour chacune des trois phases numérotées j de la tension triphasée.

Les grandeurs mesurées et calculées par le système de mesure sont ensuite affichées sur l'écran de l'interface homme-machine 90 du module de centralisation par l'intermédiaire du logiciel d'affichage 146.

Le module de centralisation 64 transmet enfin, à l'aide de son logiciel de transmission 148, ces grandeurs mesurées et calculées au serveur distant, non représenté. Le serveur distant est propre à effectuer une gestion centralisée des grandeurs mesurées et calculées pour chaque système de mesure 20.

Le module de centralisation 64 se prépare ensuite à recevoir le prochain premier message M1 du module primaire et le deuxième message du module secondaire autorisé à émettre la prochaine fois selon le mécanisme de jeton distribué, par exemple le message M2A.

Le système de mesure 20 selon l'invention est ainsi particulièrement simple à mettre en oeuvre puisqu'il suffit de connecter l'organe de mesure 66 à chacun des conducteurs primaires 34, 36, 38 sans se préoccuper de savoir à quelle phase correspond chacun des conducteurs primaires 34, 36, 38. Le procédé de mesure selon l'invention identifie en effet, automatiquement et sans intervention humaine, la phase correspondant à chacune des tensions mesurées Va, Vb, Vc.

En outre, l'utilisateur est averti du repérage correct des sondes de tension via l'émission du premier signal par le premier logiciel d'indication 109, ce qui facilite encore l'utilisation du système de mesure 20.

En complément, il suffit également d'associer chaque capteur de courant 76A à un conducteur secondaire correspondant 42A, 44A, 46A sans se préoccuper de savoir à quelle phase correspond chacun des conducteurs secondaires 42A, 44A, 46A. Le procédé de mesure selon l'invention identifie en effet également automatiquement la phase correspondant à chacune des intensités mesurées Ix, Iy, Iz.

Ceci est particulièrement adapté aux capteurs de courant 76A en forme de pince qui sont susceptibles d'être enlevés, puis remis en place facilement et fréquemment. Ceci est aussi bien adapté aux capteurs de courants 76A en forme de tore souple qui sont susceptibles d'être ouverts pour le montage et leur démontage.

En outre, l'utilisateur est également averti du repérage correct des capteurs de courant via l'émission du deuxième signal par le deuxième logiciel d'indication 126A, ce qui facilite encore davantage l'utilisation du système de mesure 20. Chaque capteur de courant comporte un organe de visualisation de ce deuxième signal, l'organe de visualisation étant par exemple une diode électroluminescente, ce qui permet à l'utilisateur de savoir directement la phase à laquelle chaque capteur de courant est associé.

L'homme du métier comprendra que les deuxièmes dispositifs d'identification de la phase correspondant à chacune des trois intensités mesurées 125A, ..., 125N ne sont pas nécessairement distincts du premier dispositif d'identification de la phase correspondant à chacune des deux autres tensions mesurées 101, le premier dispositif 101 et les deuxièmes dispositifs 125A, ..., 125N étant susceptibles de former un même dispositif.

La figure 7 illustre un deuxième mode de réalisation pour lequel les éléments analogues au premier mode de réalisation, décrit précédemment, sont repérés par des références identiques, et ne sont pas décrits à nouveau.

Selon le deuxième mode de réalisation, l'identification de la phase correspondant à chacune des tensions mesurées Va, Vb, Vc est effectuée de manière identique à ce qui a été décrit pour le premier mode de réalisation, et l'identification de la phase correspondant à chacune des intensités mesurées Ix, Iy, Iz est effectuée selon une variante de ce qui a été décrit pour le premier mode de réalisation.

La mémoire 116 est apte à stocker, en lieu et place du deuxième logiciel de comparaison 124A, un troisième logiciel de comparaison, pour chaque intensité mesurée Ix, Iy, Iz, des coordonnées du vecteur de Fresnel Ix, Iy, Iz de ladite intensité mesurée avec les coordonnées du vecteur de Fresnel V1, V2, V3 d'une tension mesurée et identifiée respective.

Le deuxième logiciel de détermination 121A, le deuxième logiciel de calcul 122A, et le troisième logiciel de comparaison forment alors la deuxième application d'identification 125A.

Les étapes, visibles sur la figure 7, du procédé de mesure mises en oeuvre par les modules secondaires 62A, ...62N pour l'identification, selon le deuxième mode de réalisation, de la phase correspondant à chacune des trois intensités mesurées Ix, Iy, Iz vont être à présent décrites pour le premier module secondaire 62A.

L'étape initiale 300 est identique à l'étape 200 décrite précédemment pour le premier mode de réalisation.

Le premier module secondaire 62A mesure notamment, lors de cette étape 300 et par l'intermédiaire de ses capteurs de courant 76A, chacune des première, deuxième et troisième intensités Ix, Iy, Iz, et le deuxième logiciel d'échantillonnage 118A échantillonne les valeurs mesurées des trois intensités Ix, Iy, Iz, l'instant de début de l'échantillonnage ayant été réinitialisé précédemment afin d'assurer la synchronisation temporelle du capteur de l'intensité 76A par rapport à l'organe de mesure de la tension 66.

Lors de l'étape 310, le deuxième logiciel de détermination 121A commence par déterminer le ou les premiers coefficients Re_k(Ij) et Im_k(Ij) de chacune des intensités mesurées Ix, Iy, Iz, à l'aide des équations (4) et (5), où j est égal à x, y, z, et k est compris entre 1 et K.

Le deuxième logiciel de calcul 122A normalise ensuite les intensités mesurées Ix, Iy, Iz afin d'obtenir des intensités normalisées Jx, Jy, Jz selon les équations suivantes :

$$\mathrm{Re_1(Jj)} = \mathrm{Re_1(Ij)} \times \frac{\mathrm{Mod(V1)}}{\mathrm{Mod(Ij)}} \qquad (24)$$

$$\mathrm{Im_1(Jj)} = \mathrm{Im_1(Ij)} \times \frac{\mathrm{Mod(V1)}}{\mathrm{Mod(Ij)}} \qquad (25)$$

où j est respectivement égal à x, y et z.

A l'issue de cette normalisation des intensités mesurées, le module des vecteurs de Fresnel des intensités normalisées Jx, Jy, Jz est alors égal au module du vecteur de Fresnel V1 de la première tension mesurée.

Lors des étapes 320 à 360, le troisième logiciel de comparaison compare successivement les vecteurs de Fresnel de chacune des intensités normalisées Jx, Jy, Jz avec les vecteurs de Fresnel V1, V2, V3 de chacune des tensions associées respectivement aux première, deuxième et troisième phases.

Le troisième logiciel de comparaison commence, par exemple, par comparer le vecteur de Fresnel de la première intensité normalisée Jx avec les vecteurs de Fresnel V1, V2, V3 de chacune des tensions lors de l'étape 320.

La comparaison consiste, par exemple, à comparer les premiers coefficients de la décomposition en série de Fourier de la première intensité normalisée Jx avec les premiers coefficients correspondants du vecteur de Fresnel Vj de la tension correspondante selon les inéquations suivantes :

$$\mathrm{Re}_1(Vj) - C2 \times Mod(Vj) < \mathrm{Re}_1(\mathrm{J}x) < \mathrm{Re}_1(Vj) + C2 \times Mod(Vj) \qquad (26)$$

$$\mathrm{Im}_1(Vj) - C2 \times Mod(Vj) < \mathrm{Im}_1(\mathrm{J}x) < \mathrm{Im}_1(Vj) + C2 \times Mod(Vj) \qquad (27)$$

où C2 est un deuxième facteur, j est égal à 1, 2 ou 3, et

Mod(Vj) représente le module du vecteur de Fresnel Vj de la tension correspondante.

D'après les inéquations (26) et (27), la comparaison entre le vecteur de Fresnel de la première intensité normalisée Jx et le vecteur de Fresnel Vj de la tension correspondante est effectuée avec une deuxième tolérance d'erreur égale à C2 fois le module du vecteur de Fresnel Vj de la tension correspondante à la fois en abscisse et en ordonnée.

Dans le mode de réalisation décrit, le deuxième facteur C2 est égal 0,4, la deuxième tolérance d'erreur correspond à une deuxième tolérance angulaire de l'ordre de +/-25° à +/-35°.

Si les inéquations (26) et (27) sont respectées pour le vecteur de Fresnel V1 de la première tension, alors le troisième logiciel de comparaison considère lors de l'étape 330 que la première intensité mesurée Ix correspond à la première phase, c'est-à-dire que Ix est égal à I1, et le troisième logiciel de comparaison passe à l'étape 340.

Sinon, le troisième logiciel de comparaison poursuit l'étape 320 en comparant, de manière analogue à l'aide des inéquations (26) et (27), le vecteur de Fresnel de la première intensité normalisée Jx avec le vecteur de Fresnel Vj de la tension suivante.

Si les inéquations (26) et (27) sont respectées pour le vecteur de Fresnel Vj, alors le troisième logiciel de comparaison considère lors de l'étape 330 que la première intensité mesurée Ix correspond à la phase associée au vecteur de Fresnel Vj pour lequel les inéquations (26) et (27) sont respectées, c'est-à-dire que Ix est égal à Ij.

Si les inéquations (26) et (27) sont respectées pour le vecteur de Fresnel V3 de la troisième tension, alors le troisième logiciel de comparaison considère lors de l'étape 330 que la première intensité mesurée Ix correspond à la troisième phase, c'est-à-dire que Ix est égal à I3, et passe à l'étape 340.

Sinon, le troisième logiciel de comparaison passe également à l'étape 340 étant donné que l'identification de la première intensité mesurée Ix a été testée pour chacune des phases.

La deuxième application d'identification 125A cherche alors, lors des étapes 340 et 350, à identifier de manière analogue la phase correspondant à la deuxième intensité mesurée Iy.

Le troisième logiciel de comparaison compare alors le vecteur de Fresnel de la deuxième intensité normalisée Jy avec les vecteurs de Fresnel V1, V2, V3 de chacune des tensions lors de l'étape 340, par exemple à l'aide des inéquations suivantes :

$$\mathrm{Re}_1(Vj) - C2 \times Mod(Vj) < \mathrm{Re}_1(\mathrm{J}y) < \mathrm{Re}_1(Vj) + C2 \times Mod(Vj) \qquad (28)$$

$$\mathrm{Im}_1(Vj) - C2 \times Mod(Vj) < \mathrm{Im}_1(\mathrm{J}y) < \mathrm{Im}_1(Vj) + C2 \times Mod(Vj) \qquad (29)$$

Si les inéquations (28) et (29) sont respectées pour le vecteur de Fresnel V1 de la première tension, alors le troisième logiciel de comparaison considère lors de l'étape 350 que la deuxième intensité mesurée Iy correspond à la première phase, c'est-à-dire que Iy est égal à I1, et le troisième logiciel de comparaison passe à l'étape 360.

Sinon, le troisième logiciel de comparaison poursuit l'étape 340 en comparant, de manière analogue à l'aide des inéquations (28) et (29), le vecteur de Fresnel de la deuxième intensité normalisée Jy avec le vecteur de Fresnel Vj de la tension suivante.

Si les inéquations (28) et (29) sont respectées pour le vecteur de Fresnel Vj, alors le troisième logiciel de comparaison considère lors de l’étape 350 que la deuxième intensité mesurée Iy correspond à la phase associée au vecteur de Fresnel Vj pour lequel les inéquations (28) et (29) sont respectées, c’est-à-dire que Iy est égal à Ij.

Si les inéquations (28) et (29) sont respectées pour le vecteur de Fresnel V3 de la troisième tension, alors le troisième logiciel de comparaison considère lors de l’étape 350 que la deuxième intensité mesurée Iy correspond à la troisième phase, c’est-à-dire que Iy est égal à I3, et passe à l’étape 360.

Sinon, le troisième logiciel de comparaison passe également à l’étape 360 étant donné que l’identification de la deuxième intensité mesurée Iy a été testée pour chacune des phases.

La deuxième application d’identification 125A cherche enfin, lors des étapes 360 et 370, à identifier de manière analogue la phase correspondant à la troisième intensité mesurée Iz.

Le troisième logiciel de comparaison compare alors le vecteur de Fresnel de la troisième intensité normalisée Jz avec les vecteurs de Fresnel V1, V2, V3 de chacune des tensions lors de l’étape 360, par exemple à l’aide des inéquations suivantes :

$$\mathrm{Re_1}(Vj) - C2 \times Mod(Vj) < \mathrm{Re_1}(\mathrm{J}z) < \mathrm{Re_1}(Vj) + C2 \times Mod(Vj) \qquad (30)$$

$$\mathrm{Im_1}(Vj) - C2 \times Mod(Vj) < \mathrm{Im_1}(\mathrm{J}z) < \mathrm{Im_1}(Vj) + C2 \times Mod(Vj) \qquad (31)$$

De manière analogue à ce qui a été décrit précédemment, si les inéquations (30) et (31) sont respectées pour le vecteur de Fresnel V1 de la première tension, alors le troisième logiciel de comparaison considère lors de l’étape 370 que la troisième intensité mesurée Iz correspond à la première phase, c’est-à-dire que Iz est égal à I1, et passe à l’étape 375.

Sinon, le troisième logiciel de comparaison poursuit l’étape 360 en comparant, de manière analogue à l’aide des inéquations (30) et (31), le vecteur de Fresnel de la troisième intensité normalisée Jz avec le vecteur de Fresnel Vj de la tension suivante.

Si les inéquations (30) et (31) sont respectées pour le vecteur de Fresnel Vj, alors le troisième logiciel de comparaison considère lors de l’étape 370 que la troisième intensité mesurée Iz correspond à la phase associée au vecteur de Fresnel Vj pour lequel les inéquations (30) et (31) sont respectées, c’est-à-dire que Iz est égal à Ij, et passe à l’étape 375.

Si les inéquations (28) et (29) ne sont respectées pour aucun vecteur de Fresnel de tension, le troisième logiciel de comparaison passe également à l’étape 375 étant donné que l’identification de la troisième intensité mesurée Iz a été testée pour chacune des phases.

Les étapes 375, 380, 385 et 390 sont ensuite identiques respectivement aux étapes 275, 280, 285 et 290 décrites précédemment pour le premier mode de réalisation. Les transitions entre les étapes sont également identiques.

Si au moins deux intensités mesurées Ix, Iy, Iz n’ont pas été identifiées à une phase respective, la deuxième application d’identification 125A retourne à l’étape 300.

Après identification des phases, le logiciel de calcul 127A calcule, de la même façon et de manière périodique, l’énergie active $E_1+$, $E_1-$, $E_2+$, $E_2-$, $E_3+$, $E_3-$ pour chacune des trois phases à partir des valeurs des tensions V1, V2, V3 mesurées et identifiées, ainsi que des valeurs des intensités I1A, I2A, I3A mesurées par les capteurs de courant 76A et identifiées.

Le premier module secondaire 62A élabore alors son deuxième message M2A, et si c’est lui qui dispose du jeton, l’envoie ensuite au module de centralisation 64.

Les étapes du procédé de mesure mises en oeuvre par les autres modules secondaires 62B, ..., 62N sont identiques aux étapes 300 à 390 décrites précédemment pour le premier module secondaire 62A, et sont réalisées en outre de manière simultanée entre tous les modules secondaires 62A, ..., 62N de par la synchronisation temporelle effectuée à l’aide du premier message M1.

Le module de centralisation 64 effectue les mêmes traitements que ceux décrits précédemment pour le premier mode de réalisation.

Le fonctionnement de ce deuxième mode de réalisation est par ailleurs identique à celui du premier mode de réalisation décrit précédemment.

Les avantages de ce deuxième mode de réalisation sont identiques à ceux du premier mode de réalisation décrit précédemment.

On conçoit ainsi que le système de mesure 20 selon l’invention permet d’identifier de manière automatique la phase correspondant à chacune des tensions mesurées, sans que l’opérateur ait à se préoccuper de savoir à quelle phase correspond chacun des conducteurs primaires 34, 36, 38 lors de la connexion de l’organe de mesure 66 à chacun des conducteurs primaires 34, 36, 38.

## Revendications

1. Système (20) de mesure d'au moins une grandeur électrique (Va, Vb, Vc) relative à une installation électrique (16), l'installation (16) comportant des conducteurs électriques (34, 36, 38) propres à permettre la circulation d'un courant alternatif triphasé, ce système de mesure (20) comprenant :

   - un organe (66) de mesure de la tension de chacun des conducteurs électriques (34, 36, 38), chaque conducteur électrique (34, 36, 38) étant associé à une phase respective du réseau alternatif,
   - une unité de traitement d'informations (68) propre à recevoir les valeurs des tensions mesurées (Va, Vb, Vc),
   - trois capteurs de courant (76A, ..., 76N), chaque capteur de courant (76A, ..., 76N) étant propre à mesurer l'intensité du courant circulant dans le conducteur électrique (42A, ..., 46N) correspondant,

   **caractérisé en ce que** l'unité de traitement (68) comprend des moyens (103) d'association de manière prédéterminée de la première tension mesurée (Va) avec une première phase parmi les trois phases, un premier dispositif (101) d'identification de la phase correspondant à chacune des deux autres tensions mesurées (Vb, Vc) et un deuxième dispositif (125A, ..., 125N) d'identification de la phase correspondant à chacune des trois intensités mesurées (Ix, Iy, Iz), et
   **en ce que** le deuxième dispositif d'identification (125A, ..., 125N) comporte des deuxièmes moyens (121A, ..., 121N) de détermination du vecteur de Fresnel (Ix, Iy, Iz) de chacune des trois intensités mesurées, des deuxièmes moyens (122A, ..., 122N) de calcul de trois vecteurs image (Ph_θ2(Ij)) via une deuxième rotation des vecteurs de Fresnel (Ix, Iy, Iz) des trois intensités mesurées et des deuxièmes moyens (124A, ..., 124N) de comparaison, avec un intervalle prédéterminé de valeurs angulaires (]-$\alpha 1_{ref}$ ; $\alpha 2_{ref}$[) de la valeur de l'angle entre chaque vecteur image (Ph_θ2(Ij)) et un axe de référence (X).

2. Système de mesure (20) selon la revendication 1, dans lequel le premier dispositif d'identification (101) comporte des premiers moyens (104) de détermination du vecteur de Fresnel (Va, Vb, Vc) de chacune des trois tensions mesurées, des premiers moyens (105) de calcul d'un vecteur image (Ph_θ1(Vj)) via une première rotation du vecteur de Fresnel (Vj) d'une parmi les deux autres tensions mesurées et des premiers moyens (106) de comparaison du vecteur image (Ph_θ1 (Vj)) avec le vecteur de Fresnel (V1) de la première tension mesurée.

3. Système de mesure (20) selon la revendication 2, dans lequel un indice $k_p$ est associé à chaque phase à identifier, l'indice $k_p$ étant un nombre entier égal à 1 pour la première phase et prenant successivement les valeurs entières égales à 2 et 3 pour les autres phases, et dans lequel la valeur de l'angle (θ1) de la première rotation dépend de l'indice $k_p$ de la phase à identifier, la valeur de l'angle (θ1) de la première rotation étant de préférence égale à ($k_p$-1) x 120°.

4. Système de mesure (20) selon l'une quelconque des revendications précédentes, dans lequel un indice $k_p$ est associé à chaque phase à identifier, l'indice $k_p$ étant un nombre entier égal à 1 pour la première phase et prenant successivement les valeurs entières égales à 2 et 3 pour les autres phases, et dans lequel la valeur de l'angle (θ2) de la deuxième rotation dépend de l'indice $k_p$ de l'intensité mesurée.

5. Système de mesure (20) selon la revendication 4 prise avec la revendication 2, dans lequel la valeur de l'angle (θ2) de la deuxième rotation est égale à (($k_p$-1) x 120°) - R, où R représente la valeur de l'angle entre le vecteur de Fresnel (V1) de la première tension mesurée et l'axe de référence (X).

6. Système de mesure (20) selon l'une quelconque des revendications précédentes prise avec la revendication 2, dans lequel le deuxième dispositif d'identification (125A, ..., 125N) comporte des troisièmes moyens de comparaison, pour chaque intensité mesurée (Ix, Iy, Iz), des coordonnées du vecteur de Fresnel (Ix, Iy, Iz) de ladite intensité mesurée avec les coordonnées du vecteur de Fresnel d'une tension de phase (V1, V2, V3) respective.

7. Système de mesure (20) selon l'une quelconque des revendications précédentes, dans lequel le système de mesure (20) comprend en outre un dispositif (109) d'indication de fin d'identification propre à émettre un premier signal, tel qu'un premier signal lumineux, lorsque le premier dispositif d'identification (101) a identifié la phase correspondant à chacune des tensions mesurées (Va, Vb, Vc).

8. Système de mesure (20) selon l'une quelconque des revendications précédentes, dans lequel le système de mesure (20) est prévu pour une installation électrique (16) comportant des conducteurs électriques primaires (34, 36, 38) et des conducteurs électriques secondaires (42A, 42B, ..., 42N, 44A, 44B, ..., 44N, 46A, 46B, ..., 46N) propres à permettre la circulation du courant alternatif, chaque conducteur électrique secondaire (42A, ..., 46N) étant relié électriquement à un conducteur électrique primaire (34, 36, 38) correspondant, le conducteur primaire (34, 36, 38) et le conducteur secondaire (42A, ..., 46N) correspondant présentant sensiblement la même tension alternative (V1, V2, V3),
dans lequel le système de mesure (20) comprend :

- un module primaire (60) comportant l'organe de mesure de la tension (66), l'organe de mesure de la tension (66) étant propre à mesurer la tension de chaque conducteur primaire (34, 36, 38),
- au moins un module secondaire (62A, ..., 62N) comportant les trois capteurs de courant (76A, ..., 76N), chaque capteur de courant étant propre à mesurer l'intensité du courant circulant dans le conducteur secondaire (42A, ..., 46N) correspondant, le ou chaque module secondaire (62A, ..., 62N) étant relié au module primaire (60) par une liaison de données correspondante,

le module primaire (60) comportant en outre des moyens (107) d'émission, à destination du récepteur radioélectrique (80A, ..., 80N) du ou de chaque module secondaire (62A, 62B, ..., 62N), d'un premier message (M1) contenant les valeurs de tensions mesurées (Va, Vb, Vc),
le ou chaque module secondaire (62A, ..., 62N) comportant des moyens de réception du premier message (M1), et le système de mesure (20) comprenant des moyens (120A, ..., 120N) de synchronisation temporelle des intensités mesurées (Ix, Iy, Iz) par rapport aux tensions mesurées (Va, Vb, Vc).

**9.** Poste (10) de transformation d'un courant électrique présentant une première tension alternative triphasée en un courant électrique présentant une deuxième tension alternative triphasée, le poste de transformation (10) comprenant :

- un premier tableau (14) comportant des conducteurs électriques d'arrivée (24A, 26A, 28A, 24B, 26B, 28B) propres à être relié à un réseau électrique (12), chaque conducteur d'arrivée (24A, ..., 28B) étant associé à une phase respective de la première tension alternative,
- un deuxième tableau (16) comportant des conducteurs électriques primaires de départ (34, 36, 38) et des conducteurs électriques secondaires de départ (42A, 44A, 46A, 42B, 44B, 46B, ..., 42N, 44N, 46N), chaque conducteur secondaire de départ (42A, ..., 46N) étant connecté électriquement à un conducteur primaire de départ (34 ; 36 ; 38) correspondant, chaque conducteur de départ (34, 42A, ..., 46N) étant associé à une phase respective de la deuxième tension alternative,
- un transformateur électrique (18) connecté entre le premier tableau (14) et le deuxième tableau (16) et propre à transformer la première tension alternative en la deuxième tension alternative, et
- un système (20) de mesure d'au moins une grandeur électrique relative au deuxième tableau (16),

**caractérisé en ce que** le système de mesure (20) est conforme à l'une quelconque des revendications précédentes.

**10.** Procédé de mesure d'au moins une grandeur électrique (Va, Vb, Vc) relative à une installation électrique (16), l'installation (16) comportant des conducteurs électriques (34, 36, 38) propres à permettre la circulation d'un courant alternatif triphasé, le procédé comprenant les étapes suivantes :

- la mesure (150), par un organe de mesure (66), de la tension de chacun des conducteurs électriques (34, 36, 38), chaque conducteur électrique (34, 36, 38) étant associé à une phase respective du réseau alternatif,
- la réception (150), par une unité de traitement d'informations (68), des valeurs des tensions mesurées (Va, Vb, Vc),

le procédé étant **caractérisé en ce qu'**il comprend en outre les étapes suivantes :

- l'association (155), par l'unité de traitement d'informations (68), de manière prédéterminée de la première tension mesurée (Va) avec une première phase parmi les trois phases,
- l'identification (165, 180), par un premier dispositif d'identification (101), de la phase correspondant à chacune des deux autres tensions mesurées (Vb, Vc),
- la mesure (200 ; 300), par trois capteurs de courant (76A, ..., 76N), de l'intensité du courant circulant dans chacun des conducteurs électriques (42A, ..., 46N), et
- l'identification (230, 250, 270 ; 330, 350, 370), par un deuxième dispositif d'identification (125A, ..., 125N)), de la phase correspondant à chacune des trois intensités mesurées (Ix, Iy, Iz),

dans lequel l'étape d'identification (230, 250, 270 ; 330, 350, 370) de la phase correspondant à chacune des trois intensités mesurées comporte la détermination du vecteur de Fresnel (Ix, Iy, Iz) de chacune des trois intensités mesurées, le calcul de trois vecteurs image (Ph_θ2(Ij)) via une deuxième rotation des vecteurs de Fresnel (Ix, Iy, Iz) des trois intensités mesurées et la comparaison, avec un intervalle prédéterminé de valeurs angulaires (]-$\alpha 1_{ref}$ ; $\alpha 2_{ref}$[) de la valeur de l'angle entre chaque vecteur image (Ph_θ2(Ij)) et un axe de référence (X).

**11.** Procédé selon la revendication 10, dans lequel un indice $k_p$ est associé à chaque phase à identifier, l'indice $k_p$ étant un nombre entier égal à 1 pour la première phase et prenant successivement les valeurs entières égales à 2 et 3 pour les autres phases, et dans lequel la valeur de l'angle (θ2) de la deuxième rotation dépend de l'indice $k_p$ de l'intensité mesurée,
la valeur de l'angle (θ2) de la deuxième rotation étant de préférence égale à (($k_p$-1) x 120°) - R, où R représente la valeur de l'angle entre le vecteur de Fresnel (V1) de la première tension mesurée et l'axe de référence (X).

## Patentansprüche

**1.** System (20) zum Messen mindestens einer elektrischen Größe (Va, Vb, Vc) in Bezug auf eine elektrische Anlage (16), wobei die Anlage (16) elektrische Leiter (34, 36, 38) umfasst, die sich dazu eignen, das Fließen eines dreiphasigen Wechselstroms zuzulassen, wobei dieses Messsystem (20) umfasst:

- eine Einrichtung (66) zum Messen der Spannung jedes der elektrischen Leiter (34, 36, 38), wobei jeder elektrische Leiter (34, 36, 38) einer jeweiligen Phase des Wechselstromnetzes zugeordnet ist,
- eine Informationsverarbeitungseinheit (68), die sich dazu eignet, Werte der gemessenen Spannungen (Va, Vb, Vc) aufzunehmen,
- drei Stromsensoren (76A, ..., 76N), wobei sich jeder Stromsensor (76A, ..., 76N) dazu eignet, die Stärke des im entsprechenden elektrischen Leiter (42A, ..., 46N) fließenden Stroms zu messen,

**dadurch gekennzeichnet, dass** die Verarbeitungseinheit (68) Mittel (103) umfasst, um die erste gemessene Spannung (Va) auf vorbestimmte Weise mit einer ersten Phase unter den drei Phasen zu assoziieren, wobei eine erste Vorrichtung (101) zur Erkennung der Phase jeweils den zwei anderen gemessenen Spannungen (Vb, Vc) entspricht) und eine zweite Vorrichtung (125A, ..., 125N) zur Erkennung der Phase jeweils drei gemessenen Stärken (Ix, Iy, Iz) entspricht, und
dass die zweite Erkennungsvorrichtung (125A, ..., 125N) zweite Mittel (121A, ..., 121N) zur Bestimmung des Fresnel-Vektors (Ix, Iy, Iz) jeweils der drei gemessenen Stärken, zweite Mittel (122A, ..., 122N) zum Berechnen von drei Bildvektoren (Ph_θ2(Ij) über eine zweite Drehung der Fresnel-Vektoren (Ix, Iy, Iz) der drei gemessenen Stärken und zweite Mittel (124A, ..., 124N) zum Vergleichen, mit einem vorbestimmten Intervall von Winkelwerten (]-$\alpha 1_{ref}$; $\alpha 2_{ref}$[), des Werts des Winkels zwischen jedem Bildvektor (Ph_θ2(Ij) und einer Referenzachse (X) umfasst.

**2.** Messsystem (20) nach Anspruch 1, wobei die erste Erkennungsvorrichtung (101) erste Mittel (104) zur Bestimmung des Fresnel-Vektors (Va, Vb, Vc) jeweils der drei gemessenen Spannungen, erste Mittel (105) zur Berechnung eines Bildvektors (Ph_θ1(Vj) über eine erste Drehung des Fresnel-Vektors (Vj) einer unter den zwei anderen gemessenen Spannungen und erste Mittel (106) zum Vergleichen des Bildvektors (Ph_θ1(Vj) mit dem Fresnel-Vektor (V1) der ersten gemessenen Spannung umfasst.

**3.** Messsystem (20) nach Anspruch 2, wobei ein Index $k_p$ jeder zu erkennenden Phase zugeordnet ist, wobei der Index $k_p$ eine ganze Zahl gleich 1 für die erste Phase ist und sukzessive ganze Werte gleich 2 oder 3 für die anderen Phasen annimmt, und wobei der Wert des Winkels (θ1) der ersten Drehung vom Index $k_p$ der zu erkennenden Phase abhängt, wobei der Wert des Winkels (θ1) der ersten Drehung vorzugsweise gleich ($k_p$ - 1) x 120° ist.

**4.** Messsystem (20) nach einem der vorhergehenden Ansprüche, wobei ein Index $k_p$ jeder zu erkennenden Phase zugeordnet ist, wobei der Index $k_p$ eine ganze Zahl gleich 1 für die erste Phase ist und sukzessive ganze Werte gleich 2 oder 3 für die anderen Phasen annimmt, und wobei der Wert des Winkels (θ2) der zweiten Drehung vom Index $k_p$ der gemessenen Stärke abhängt.

**5.** Messsystem (20) nach Anspruch 4 zusammen mit Anspruch 2, wobei der Wert des Winkels (θ2) der zweiten Drehung gleich (($k_p$ - 1) x 120°) - R ist, worin R den Wert des Winkels zwischen dem Fresnel-Vektor (V1) der ersten gemessenen Spannung und der Referenzachse (X) darstellt.

**6.** Messsystem (20) nach einem der vorhergehenden Ansprüche zusammen mit Anspruch 2, wobei die zweite Erkennungsvorrichtung (125A, ..., 125N) dritte Mittel für jede gemessene Stärke (Ix, Iy, Iz) zum Vergleichen von Koordinaten des Fresnel-Vektors (Ix, Iy, Iz) der gemessenen Stärke mit den Koordinaten des Fresnel-Vektors einer jeweiligen Phasenspannung (V1, V2, V3) umfasst.

**7.** Messsystem (20) nach einem der vorhergehenden Ansprüche, wobei das Messsystem (20) darüber hinaus eine Erkennungsendeangabevorrichtung (109) umfasst, die sich dazu eignet, ein erstes Signal, wie etwa ein erstes Lichtsignal, auszugeben, wenn die erste Erkennungsvorrichtung (101) die Phase erkannt hat, die jeder der gemessenen Spannungen (Va, Vb, Vc) entspricht.

**8.** Messsystem (20) nach einem der vorhergehenden Ansprüche, wobei das Messsystem (20) für eine elektrische Anlage (16) vorgesehen ist, die primäre elektrische Leiter (34, 36, 38) und sekundäre elektrische Leiter (42A, 42B, ..., 42N, 44A, 44B, ..., 44N, 46A, 46B, ... 46N) umfasst, die sich dazu eignen, das Fließen des Wechselstroms zuzulassen, wobei jeder sekundäre elektrische Leiter (42A, ..., 46N) elektrisch an einen entsprechenden primären elektrischen Leiter (34, 36, 38) angeschlossen ist, wobei der primäre Leiter (34, 36, 38) und der entsprechende sekundäre Leiter (42A, ..., 46N) im Wesentlichen dieselbe Wechselspannung (V1, V2, V3) aufweisen,
wobei das Messsystem (20) umfasst:

- ein primäres Modul (60), das die Spannungsmesseinrichtung (66) umfasst, wobei sich die Spannungsmesseinrichtung (66) dazu eignet, die Spannung jedes primären Leiters (34, 36, 38) zu messen,
- mindestens ein sekundäres Modul (62A, ..., 62N), das die drei Stromsensoren (76A, ..., 76N) umfasst, wobei sich jeder Stromsensor dazu eignet, die Stärke des im entsprechenden sekundären Leiter (42A, ..., 46N) fließenden Stroms zu messen, wobei das oder jedes sekundäre Modul (62A, ..., 62N) über eine entsprechende Datenverbindung mit dem primären Modul (60) verbunden ist,

wobei das primäre Modul (60) darüber hinaus Mittel (107) zum Senden, mit Destination des Funkempfängers (80A, ..., 80N) des oder jedes sekundären Moduls (62A, 62B, ..., 62N), einer die Werte gemessener Spannungen (Va, Vb, Vc) enthaltenden ersten Nachricht (M1) umfasst,
wobei das oder jedes sekundäre Modul (62A, ..., 62N) Mittel zum Empfangen der ersten Nachricht (M1) umfasst, und das Messsystem (20) Mittel (120A, ..., 120N) zur zeitlichen Synchronisation der gemessenen Stärken (Ix, Iy, Iz) in Bezug auf die gemessenen Spannungen (Va, Vb, Vc) umfasst.

**9.** Station (10) zum Umspannen eines eine erste dreiphasige Wechselspannung aufweisenden elektrischen Stroms in einen elektrischen Strom, der eine zweite dreiphasige Wechselspannung aufweist, wobei die Umspannstation (10) umfasst:

- eine erste Schalttafel (14), die elektrische Eingangsleiter (24A, 26A, 28A, 24B, 26B, 28B) umfasst, die sich dazu eignen, an ein elektrisches Netz (12) angeschlossen zu werden, wobei jeder Eingangsleiter (24A, ..., 28B) einer jeweiligen Phase der ersten Wechselspannung zugeordnet ist,
- eine zweite Schalttafel (16), die primäre elektrische Ausgangsleiter (34, 36, 38) und sekundäre elektrische Ausgangsleiter (42A, 44A, 46A, 42B, 44B, 46B, ..., 42N, 44N, 46N) umfasst, wobei jeder sekundäre Ausgangsleiter (42A, ..., 46N) elektrisch an einen entsprechenden primären Ausgangsleiter (34, 36, 38) angeschlossen ist, wobei jeder Ausgangsleiter (34, 42A, ..., 46N) einer jeweiligen Phase der zweiten Wechselspannung zugeordnet ist,
- einen elektrischen Transformator (18), der zwischen der ersten Schalttafel (14) und der zweiten Schalttafel (16) zwischengeschaltet ist und sich dazu eignet, die erste Wechselspannung in die zweite Wechselspannung umzuwandeln, und
- ein System (20) zum Messen mindestens einer elektrischen Größe in Bezug auf die zweite Schalttafel (16),

**dadurch gekennzeichnet, dass** das Messsystem (20) einem der vorhergehenden Ansprüche entspricht.

**10.** Verfahren zum Messen mindestens einer elektrischen Größe (Va, Vb, Vc) in Bezug auf eine elektrische Anlage (16), wobei die Anlage (16) elektrische Leiter (34, 36, 38) umfasst, die sich dazu eignen, das Fließen eines dreiphasigen Wechselstroms zuzulassen, wobei das Verfahren die folgenden Schritte umfasst:

- Messen (150), mittels einer Messeinrichtung (66), der Spannung jedes von elektrischen Leitern (34, 36, 38), wobei jeder elektrische Leiter (34, 36, 38) einer jeweiligen Phase des Wechselstromnetzes zugeordnet ist,
- Empfangen (150), mittels einer Informationsverarbeitungseinheit (68), von Werten der gemessenen Spannungen (Va, Vb, Vc),

wobei das Verfahren **dadurch gekennzeichnet ist, dass** es darüber hinaus die folgenden Schritte umfasst:

- Assoziieren (155) auf vorbestimmte Weise, mittels der Informationsverarbeitungseinheit (68), der ersten gemessenen Spannung (Va) mit einer ersten Phase unter den drei Phasen,
- Erkennen (165, 180), mittels einer ersten Erkennungsvorrichtung (101) der Phase, die jeder der zwei anderen gemessenen Spannungen (Vb, Vc) entspricht,
- Messen (200; 300), mittels dreier Stromsensoren (76A, ..., 76N), der Stärke des Stroms, der in jedem der elektrischen Leiter (42A, ..., 46N) fließt, und
- Erkennen (230, 250, 270; 330, 350, 370), mittels einer zweiten Erkennungsvorrichtung (125A, ..., 125N), der Phase, die jeder der drei gemessenen Stärken (Ix, Iy, Iz) entspricht,

wobei der Schritt des Erkennens (230, 250, 270; 330, 350, 370) der Phase, die jeder der drei gemessenen Stärken entspricht, die Bestimmung des Fresnel-Vektors (Ix, Iy, Iz) jeder der drei gemessenen Stärken, die Berechnung von drei Bildvektoren (Ph_θ2(Ij) über eine zweite Drehung der Fresnel-Vektoren (Ix, Iy, Iz) der drei gemessenen Stärken und das Vergleichen, mit einem vorbestimmten Intervall von Winkelwerten (]-$\alpha 1_{ref}$; $\alpha 2_{ref}$[), des Werts des Winkels zwischen jedem Bildvektor (Ph_θ2(Ij) und einer Referenzachse (X) umfasst.

**11.** Verfahren nach Anspruch 10, wobei ein Index $k_p$ jeder zu erkennenden Phase zugeordnet ist, wobei der Index $k_p$ eine ganze Zahl gleich 1 für die erste Phase ist und sukzessive ganze Werte gleich 2 oder 3 für die anderen Phasen annimmt, und wobei der Wert des Winkels (θ2) der zweiten Drehung vom Index $k_p$ der gemessenen Stärke abhängt, wobei der Wert des Winkels (θ2) der zweiten Drehung vorzugsweise gleich (($k_p$ - 1) x 120°) - R ist, worin R den Wert des Winkels zwischen dem Fresnel-Vektor (V1) der ersten gemessenen Spannung und der Referenzachse (X) darstellt.

## Claims

**1.** A measuring system (20) for measuring at least one electrical quantity (Va, Vb, Vc) relative to a power installation (16), the installation (16) comprising electrical conductors (34, 36, 38) able to enable the flowing of a three-phase alternating current, the measuring system (20) comprising:

- a voltage measuring element (66) for measuring voltage of each of the electrical conductors (34, 36, 38), with each electrical conductor (34, 36, 38) being associated to a respective phase of the alternating network,
- an information processing unit (68) able to receive the values of the measured voltages (Va, Vb, Vc),
- three current sensors (76A, ..., 76N), each current sensor (76A, ..., 76N) being able to measure the intensity of the current flowing in the corresponding electrical conductor (42A, ..., 46N),

**characterised in that** the processing unit (68) comprises associating means (103) for associating in a predetermined manner the first measured voltage (Va) with a first phase among the three phases, a first identifying device (101) for identifying the phase corresponding to each of the two other measured voltages (Vb, Vc) and a second identifying device (125A, ..., 125N) for identifying the phase corresponding to each of the three measured intensities (Ix, Iy, Iz), and
**in that** the second identifying device (125A, ..., 125N) comprises second determining means (121A, ..., 121N) for determining the Fresnel vector (Ix, Iy, Iz) of each of the three measured intensities, second calculation means (122A, ..., 122N) for calculating three image vectors (Ph_θ2(Ij)) via a second rotation of the Fresnel vectors (Ix, Iy, Iz) of the three measured intensities and second comparison means (124A, ..., 124N) for comparing, with a predetermined interval of angular values (]-$\alpha 1_{ref}$ ;$\alpha 2_{ref}$[), the value of the angle between each image vector (Ph_θ2(Ij)) and a reference axis (X).

**2.** The measuring system (20) according to claim 1, wherein the first identifying device (101) comprises first determining means (104) for determining the Fresnel vector (Va, Vb, Vc) of each of the three measured voltages, first calculation means (105) for calculating an image vector (Ph_θ1 (Vj)) via a first rotation of the Fresnel vector (Vj) of one among the two other measured voltages and first comparison means (106) for comparing an image vector (Ph_θ1(Vj)) with the Fresnel vector (V1) of the first measured voltage.

**3.** The measuring system (20) according to claim 2, wherein an index $k_p$ is associated to each phase to be identified,

the index $k_p$ being an integer equal to 1 for the first phase and taking successively the integer values equal to 2 and 3 for the other phases, and wherein the value of the angle (θ1) of the first rotation depends on the index $k_p$ of the phase to be identified, the value of the angle (θ1) of the first rotation being preferably equal to ($k_p$-1) x 120°.

**4.** The measuring system (20) according to any one of the preceding claims, wherein an index $k_p$ is associated to each phase to be identified, the index $k_p$ being an integer equal to 1 for the first phase and taking successively the integer values equal to 2 and 3 for the other phases, and wherein the value of the angle (θ2) of the second rotation depends on the index $k_p$ of the measured intensity.

**5.** The measuring system (20) according to claim 4 taken with claim 2, wherein the value of the angle (θ2) of the second rotation is equal to (($k_p$-1) x 120°) - R, where R represents the value of the angle between the Fresnel vector (V1) of the first measured voltage and the reference axis (X).

**6.** The measuring system (20) according to any one of the preceding claims taken with claim 2, wherein the second identifying device (125A, ..., 125N) comprises third comparison means for comparing, for each measured intensity (Ix, ly, Iz), coordinates of the Fresnel vector (Ix, ly, Iz) of said measured intensity with the coordinates of the Fresnel vector of a respective phase voltage (V1, V2, V3).

**7.** The measuring system (20) according to any one of the preceding claims, wherein the measuring system (20) further comprises an indication device (109) for indicating the end of identification and able to emit a first signal, such as a first lighted signal, when the first identifying device (101) identified the phase corresponding to each of the measured voltages (Va, Vb, Vc).

**8.** The measuring system (20) according to any one of the preceding claims, wherein the measuring system (20) is provided for a power installation (16) comprising primary electrical conductors (34, 36, 38) and secondary electrical conductors (42A, 42B, ..., 42N, 44A, 44B, ..., 44N, 46A, 46B, ..., 46N) able to enable the flowing of the alternating current, each secondary electrical conductor (42A, ..., 46N) being electrically connected to a corresponding primary electrical conductor (34, 36, 38), with the primary conductor (34, 36, 38) and the corresponding secondary conductor (42A, ..., 46N) having substantially the same alternating voltage (V1, V2, V3),
wherein the measuring system (20) comprises:

- a primary module (60) comprising the voltage measuring element (66), the voltage measuring element (66) being able to measure the voltage of each primary conductor (34, 36, 38),
- at least one secondary module (62A, ..., 62N) comprising the three current sensors (76A, ..., 76N), each current sensor being able to measure the intensity of the current flowing in the corresponding secondary conductor (42A, ..., 46N), with the or each secondary module (62A, ..., 62N) being connected to the primary module (60) by a corresponding data link,

the primary module (60) further comprising emission means (107) for emitting, to the radio receiver (80A, ..., 80N) of the or of each secondary module (62A, 62B, ..., 62N), a first message (M1) containing the values of measured voltages (Va, Vb, Vc),
the or each secondary module (62A, ..., 62N) comprising reception means for receiving the first message (M1), and the measuring system (20) comprising synchronisation means (120A, ..., 120N) for time synchronisation of the measured intensities (Ix, ly, Iz) in relation to the measured voltages (Va, Vb, Vc).

**9.** Transforming station (10) for transforming an electric current having a first three-phase alternating voltage into an electric current having a second three-phase alternating voltage, the transforming station (10) comprising:

- a first board (14) comprising input electrical conductors (24A, 26A, 28A, 24B, 26B, 28B) able to be connected to an electrical network (12), each input conductor (24A, ..., 28B) being associated to a respective phase of the first alternating voltage,
- a second board (16) comprising primary output electrical conductors (34, 36, 38) and secondary output electrical conductors (42A, 44A, 46A, 42B, 44B, 46B, ..., 42N, 44N, 46N), each secondary output conductor (42A, ..., 46N) being connected electrically to a corresponding primary output conductor (34; 36; 38), with each output conductor (34, 42A, ..., 46N) being associated to a respective phase of the second alternating voltage,
- an electric transformer (18) connected between the first board (14) and the second board (16) and able to transform the first alternating voltage into the second alternating voltage, and
- a system (20) for measuring at least one electrical quantity relative to the second board (16),

**characterised in that** the measuring system (20) is compliant with any one of the preceding claims.

**10.** Method for measuring at least one electrical quantity (Va, Vb, Vc) relative to a power installation (16), the installation (16) comprising electrical conductors (34, 36, 38) able to enable the flowing of a three-phase alternating current, the method comprising the following steps:

- measuring (150), by a voltage measuring element (66), the voltage of each of the electrical conductors (34, 36, 38), each electrical conductor (34, 36, 38) being associated to a respective phase of the alternating network,
- receiving (150), by an information processing unit (68), the values of the measured voltages (Va, Vb, Vc),

the method being **characterised in that** it further comprises the following steps:

- associating (155), by the information processing unit (68), in a predetermined manner the first measured voltage (Va) with a first phase among the three phases,
- identifying (165, 180), by a first identifying device (101), the phase corresponding to each of the two other measured voltages (Vb, Vc),
- measuring (200; 300), by three current sensors (76A, ..., 76N), the intensity of the current flowing in each of the electrical conductors (42A, ..., 46N), and
- identifying (230, 250, 270; 330, 350, 370), by a second identifying device (125A, ..., 125N)), the phase corresponding to each of the three measured intensities (Ix, Iy, Iz), wherein the step of identifying (230, 250, 270; 330, 350, 370) the phase corresponding to each of the three measured intensities comprises determining the Fresnel vector (Ix, Iy, Iz) of each of the three measured intensities, calculating three image vectors (Ph_θ2(Ij)) via a second rotation of the Fresnel vectors (Ix, Iy, Iz) of the three measured intensities and comparing, with a predetermined interval of angular values (]-$\alpha 1_{ref}$ ; $\alpha 2_{ref}$[), the value of the angle between each image vector (Ph_θ2(Ij)) and a reference axis (X).

**11.** Method according to claim 10, wherein an index $k_p$ is associated to each phase to be identified, the index $k_p$ being an integer equal to 1 for the first phase and taking successively the integer values equal to 2 and 3 for the other phases, and wherein the value of the angle (θ2) of the second rotation depends on the index $k_p$ of the measured intensity,
the value of the angle (θ2) of the second rotation being more preferably equal to (($k_p$-1) x 120°) - R, where R represents the value of the angle between the Fresnel vector (V1) of the first measured voltage and the reference axis (X).

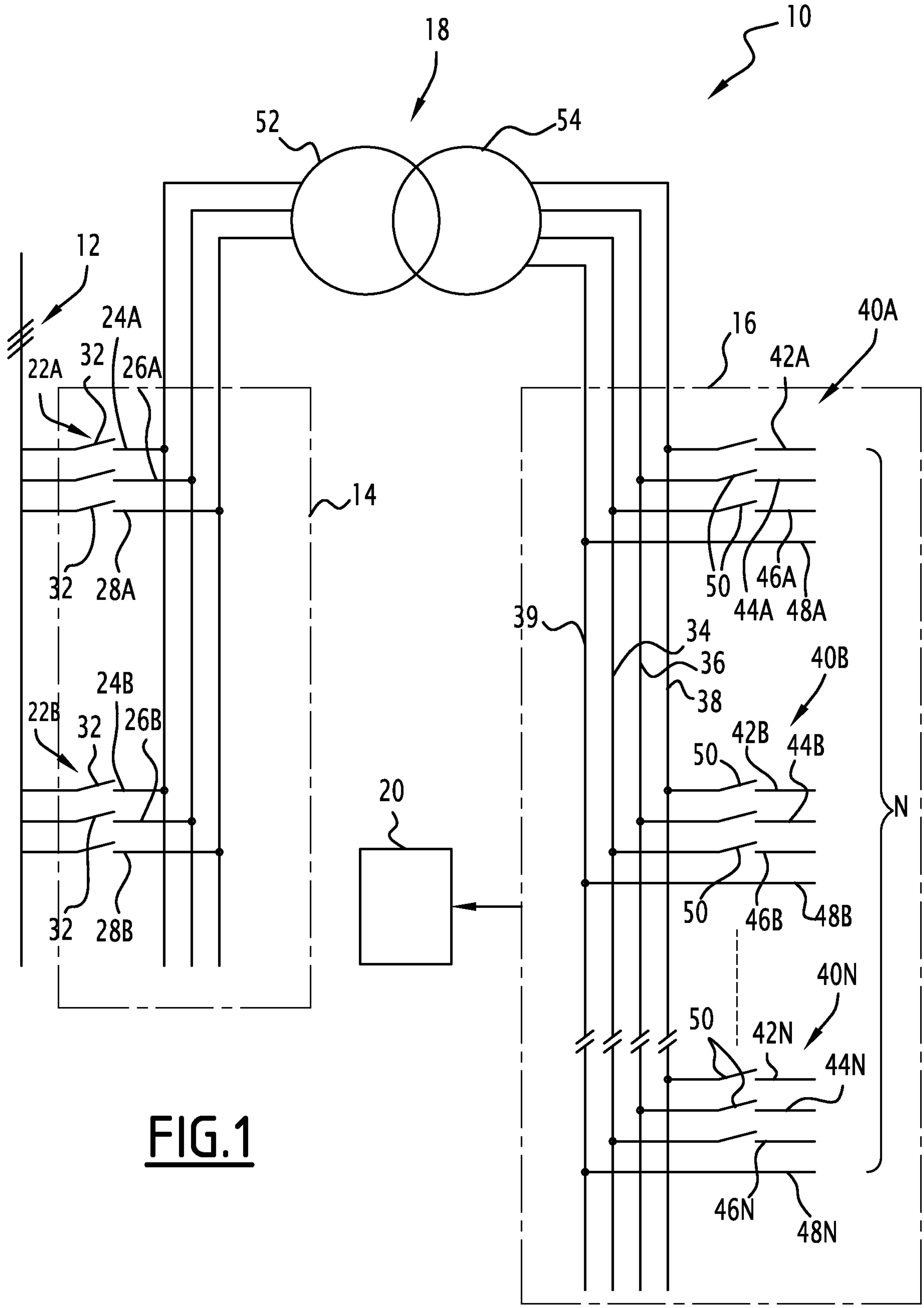
10
18
52
54
12
24A
32
22A
26A
32
28A
14
16
40A
42A
50
46A
44A
48A
39
34
36
38
40B
24B
22B
32
26B
32
28B
50
42B
44B
20
N
50
46B
48B
40N
50
42N
44N
46N
48N

FIG.1

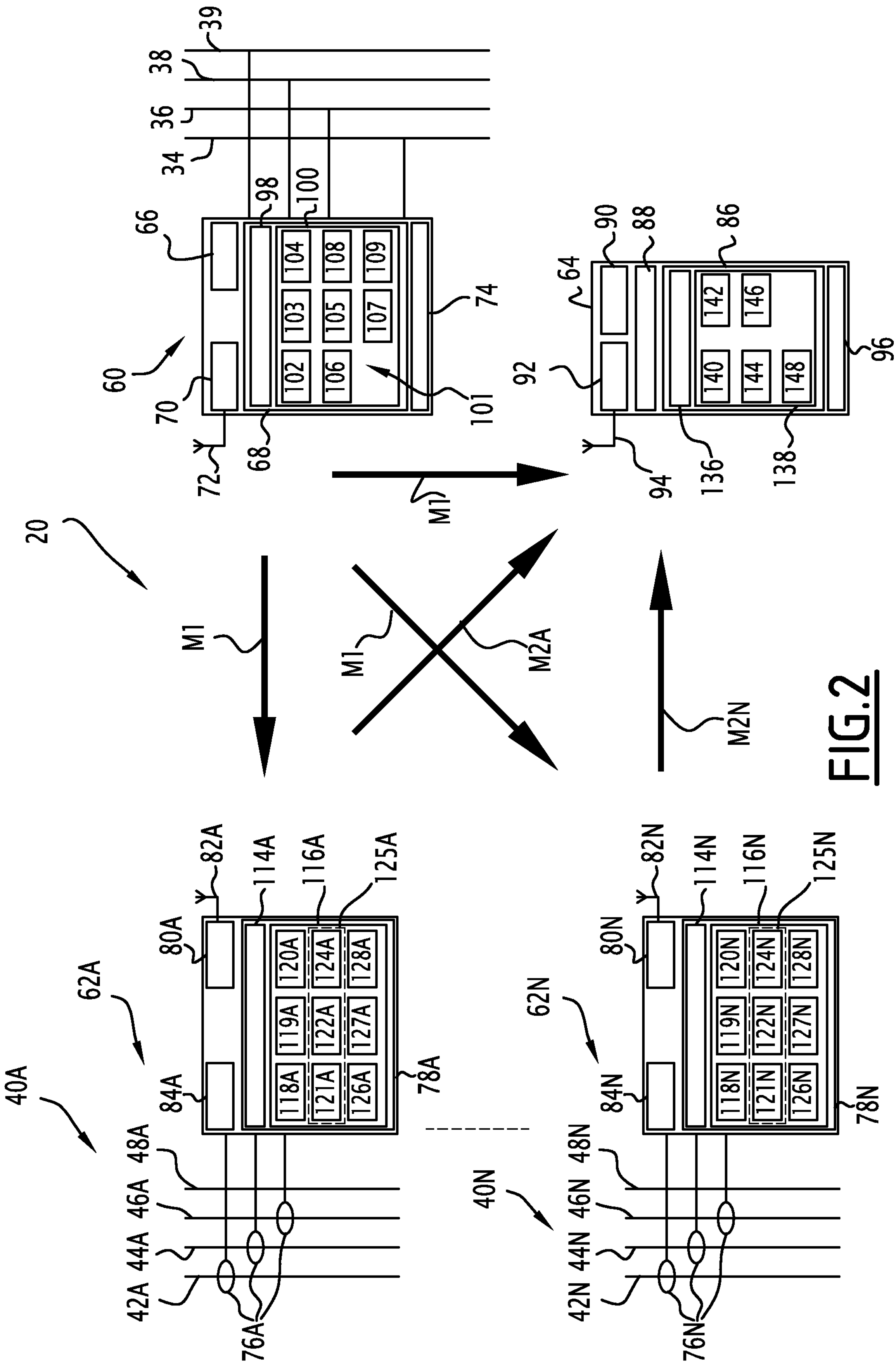
20
60
66
70
72
68
98
100
34
36
38
39
101
102
103
104
105
106
107
108
109
74
64
90
88
86
92
94
136
138
140
142
144
146
148
96
M1
M2A
M2N
40A
62A
80A
82A
84A
114A
116A
125A
118A
119A
120A
121A
122A
124A
126A
127A
128A
78A
42A
44A
46A
48A
76A
40N
62N
80N
82N
84N
114N
116N
125N
118N
119N
120N
121N
122N
124N
126N
127N
128N
78N
42N
44N
46N
48N
76N

FIG.2

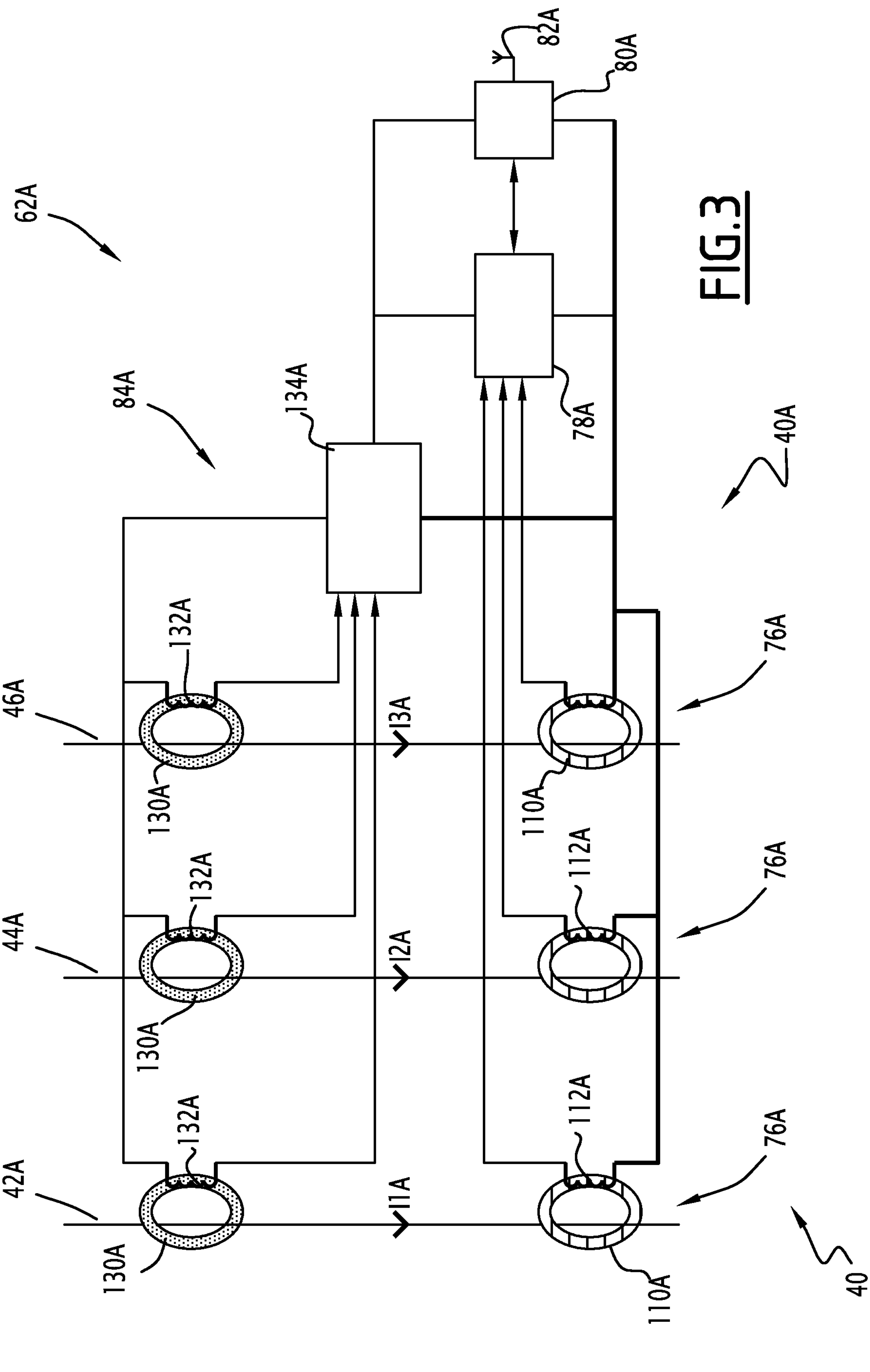
62A
84A
134A
82A
80A
78A
40A
46A
44A
42A
132A
132A
132A
130A
130A
130A
I3A
I2A
I1A
110A
112A
112A
110A
76A
76A
76A
40

FIG.3

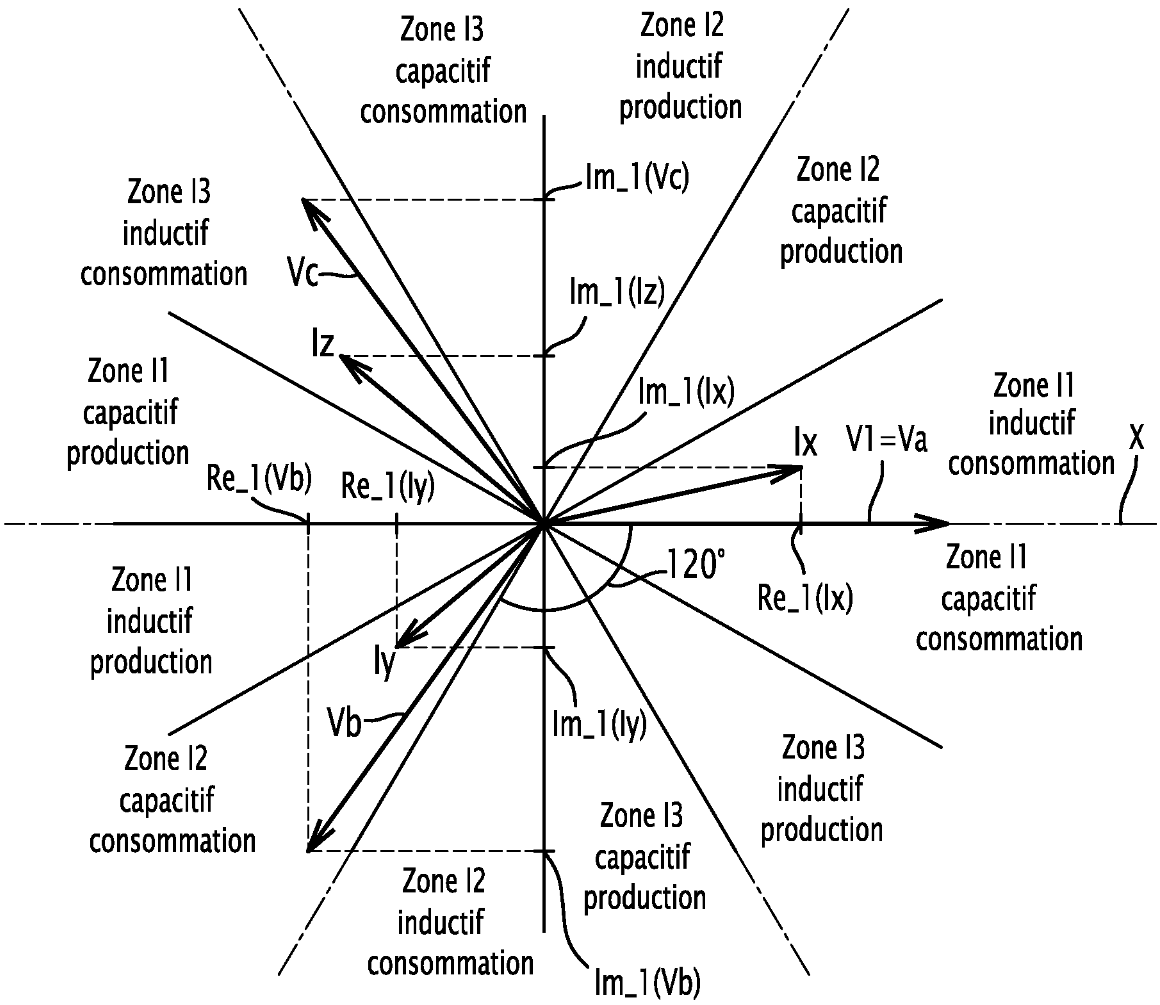
Zone I3
capacitif
consommation
Zone I2
inductif
production
Zone I3
inductif
consommation
Im_1(Vc)
Zone I2
capacitif
production
Vc
Im_1(Iz)
Iz
Zone I1
capacitif
production
Im_1(Ix)
Zone I1
inductif
consommation
Ix
V1=Va
X
Re_1(Vb)
Re_1(Iy)
120°
Zone I1
inductif
production
Re_1(Ix)
Zone I1
capacitif
consommation
Iy
Vb
Im_1(Iy)
Zone I2
capacitif
consommation
Zone I3
inductif
production
Zone I3
capacitif
production
Zone I2
inductif
consommation
Im_1(Vb)

FIG.4

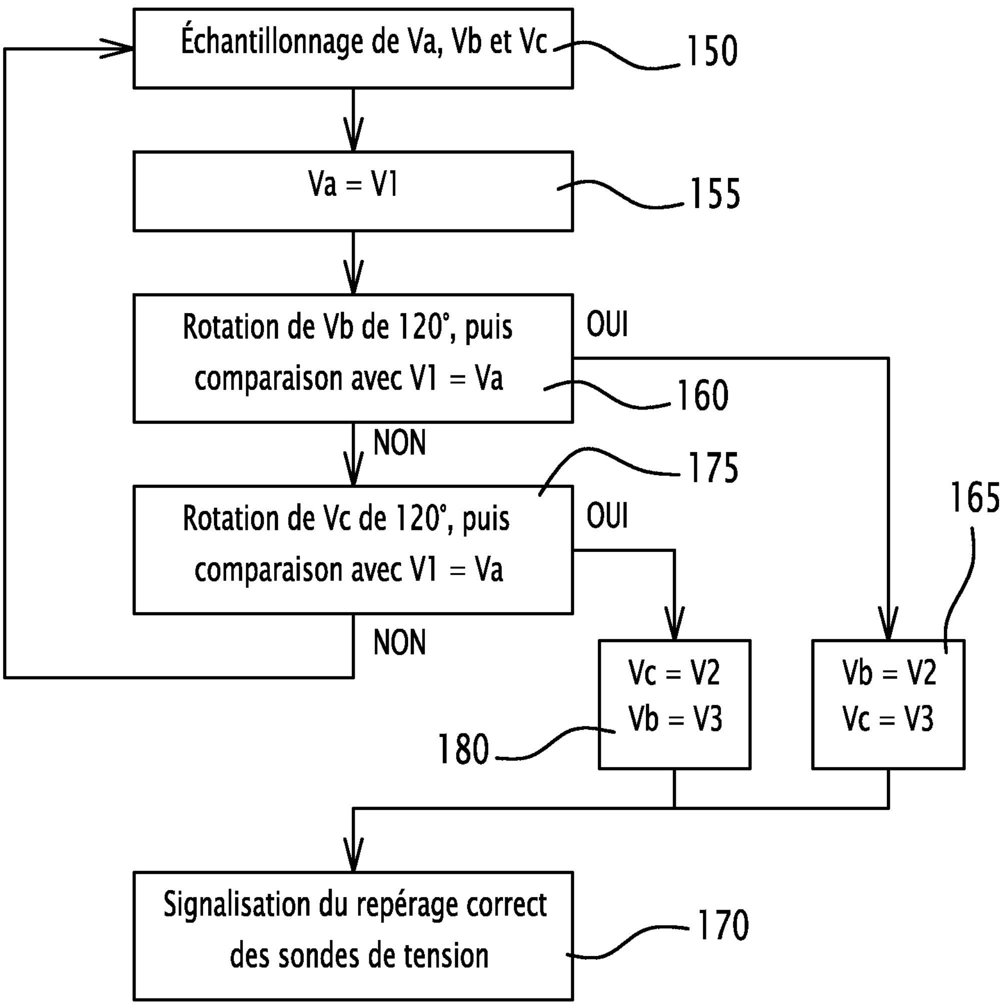
Échantillonnage de Va, Vb et Vc
150
Va = V1
155
Rotation de Vb de 120°, puis comparaison avec V1 = Va
OUI
160
NON
175
Rotation de Vc de 120°, puis comparaison avec V1 = Va
OUI
165
NON
Vc = V2
Vb = V3
180
Vb = V2
Vc = V3
Signalisation du repérage correct des sondes de tension
170

FIG.5

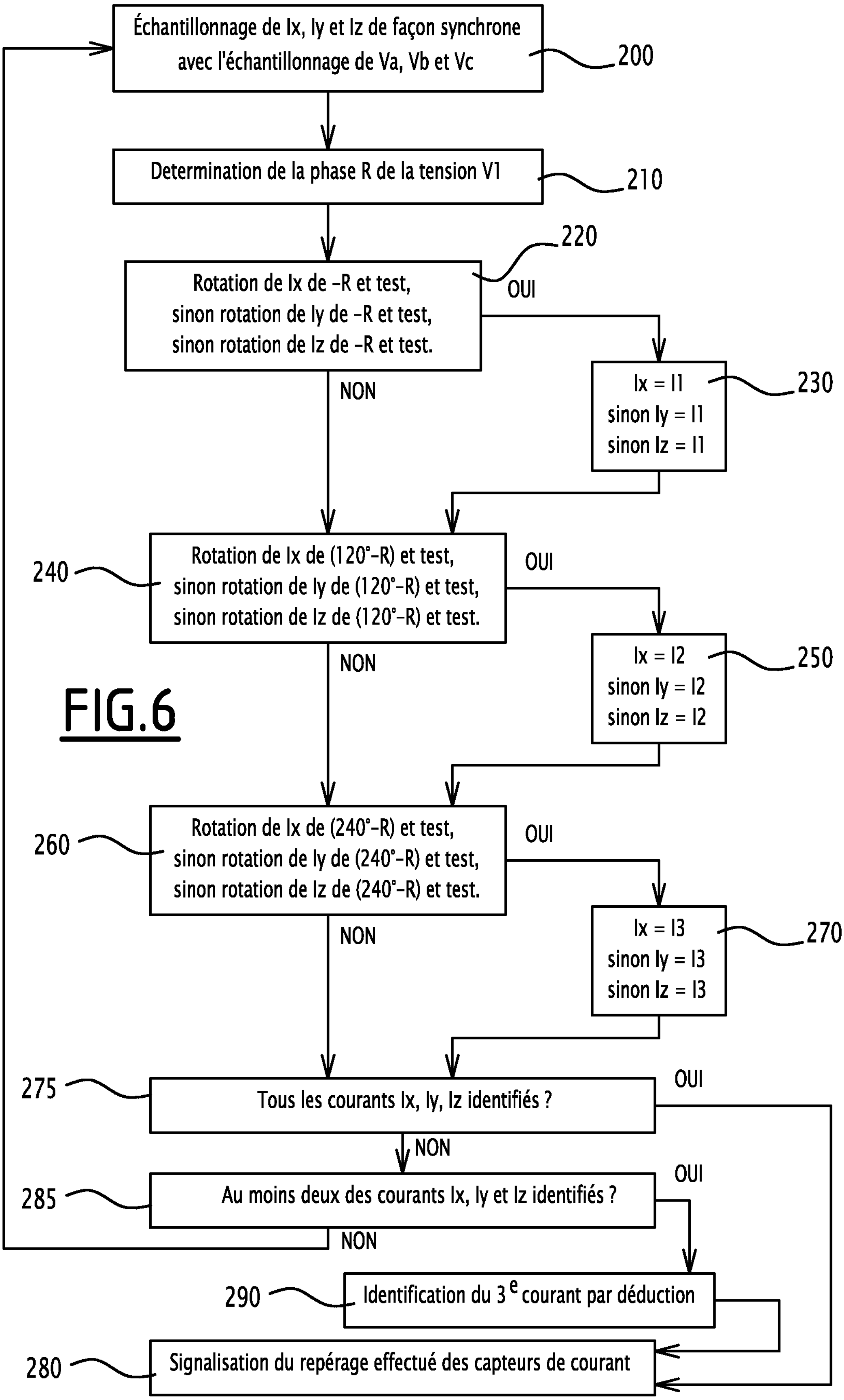
Échantillonnage de Ix, Iy et Iz de façon synchrone avec l'échantillonnage de Va, Vb et Vc
200
Determination de la phase R de la tension V1
210
220
Rotation de Ix de –R et test, sinon rotation de Iy de –R et test, sinon rotation de Iz de –R et test.
OUI
NON
Ix = I1 sinon Iy = I1 sinon Iz = I1
230
240
Rotation de Ix de (120°–R) et test, sinon rotation de Iy de (120°–R) et test, sinon rotation de Iz de (120°–R) et test.
OUI
NON
Ix = I2 sinon Iy = I2 sinon Iz = I2
250
260
Rotation de Ix de (240°–R) et test, sinon rotation de Iy de (240°–R) et test, sinon rotation de Iz de (240°–R) et test.
OUI
NON
Ix = I3 sinon Iy = I3 sinon Iz = I3
270
275
Tous les courants Ix, Iy, Iz identifiés ?
OUI
NON
285
Au moins deux des courants Ix, Iy et Iz identifiés ?
OUI
NON
290
Identification du 3 e courant par déduction
280
Signalisation du repérage effectué des capteurs de courant

FIG.6

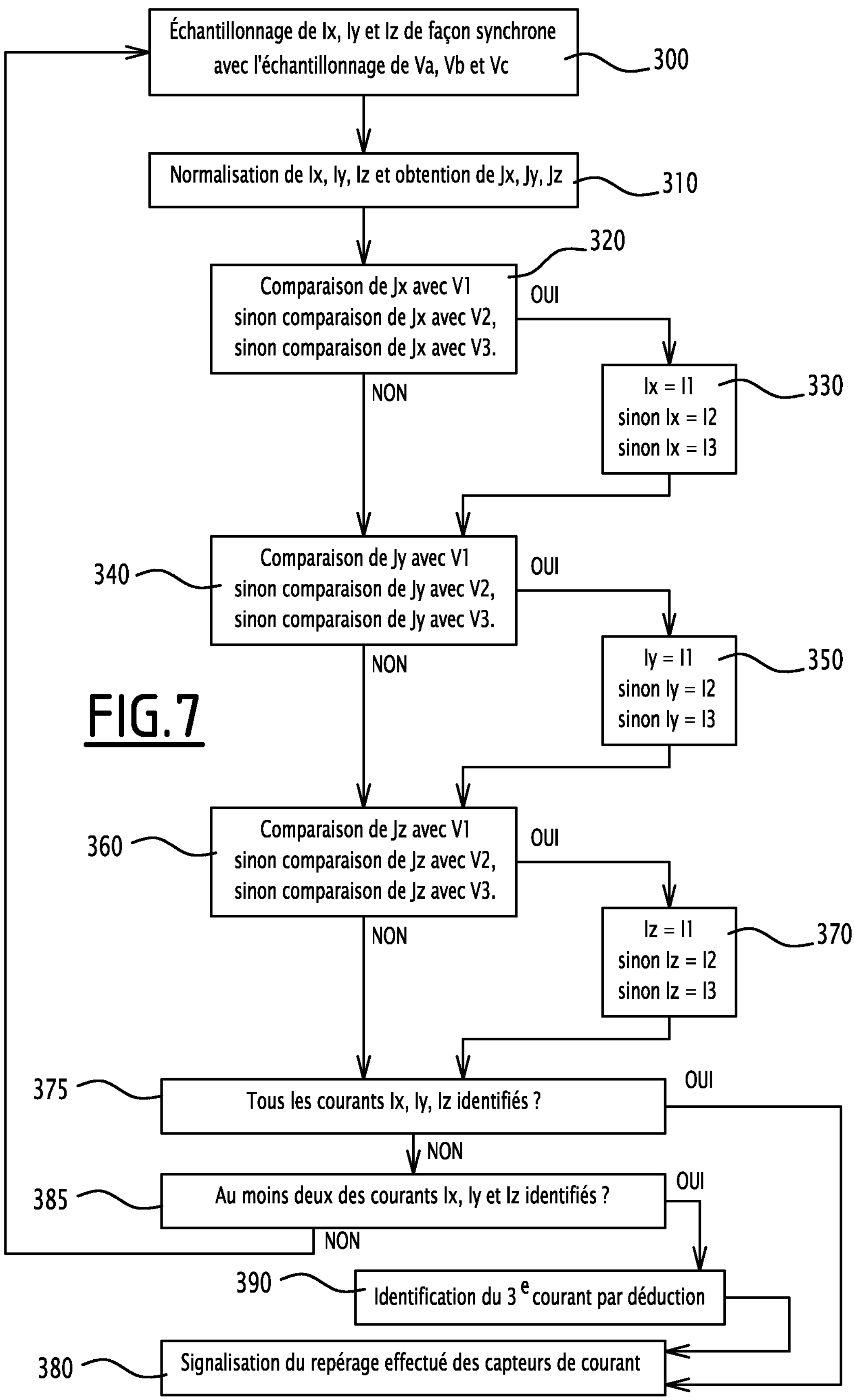
Échantillonnage de Ix, Iy et Iz de façon synchrone avec l'échantillonnage de Va, Vb et Vc
300
Normalisation de Ix, Iy, Iz et obtention de Jx, Jy, Jz
310
320
Comparaison de Jx avec V1 sinon comparaison de Jx avec V2, sinon comparaison de Jx avec V3.
OUI
NON
Ix = I1 sinon Ix = I2 sinon Ix = I3
330
340
Comparaison de Jy avec V1 sinon comparaison de Jy avec V2, sinon comparaison de Jy avec V3.
OUI
NON
Iy = I1 sinon Iy = I2 sinon Iy = I3
350
360
Comparaison de Jz avec V1 sinon comparaison de Jz avec V2, sinon comparaison de Jz avec V3.
OUI
NON
Iz = I1 sinon Iz = I2 sinon Iz = I3
370
375
Tous les courants Ix, Iy, Iz identifiés ?
OUI
NON
385
Au moins deux des courants Ix, Iy et Iz identifiés ?
OUI
NON
390
Identification du 3 e courant par déduction
380
Signalisation du repérage effectué des capteurs de courant

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 7425778 B2
- WO 2010065591 A
- US 20070279039 A
- FR 1157170
- FR 1254796